# EUROPÄISCHE PATENTANMELDUNG

(11) **EP 1 453 117 A2**
(43) Veröffentlichungstag der Anmeldung: **01.09.2004**
(21) Anmeldenummer: 04000418.6
(22) Anmeldetag: 12.01.2004
(51) Int. Cl.: H01L 51/20

(54) **Verfahren zur Herstellung organischer lichtemittierender Dioden und organische lichtemittierende Diode**

(30) Priorität: 26.02.2003 DE 10308515
(71) Anmelder: Schott Glas, 55122 Mainz (DE); CARL-ZEISS-STIFTUNG trading as Schott Glas, 55122 Mainz (DE)
(72) Erfinder: Ottermann, Clemens, Dr., 65795 Hattersheim (DE); Schultheis, Bernd, 55270 Schwabenheim (DE); Köbrich, Holger, 65439 Flörsheim (DE); Hertel, Dirk, Dr., 65185 Wiesbaden (DE); Effenberger, Ruth, 55278 Undenheim (DE); Hammerl, Klaus Michael, 65344 Martinsthal (DE)
(74) Vertreter: Herden, Andreas F.

(57) **Zusammenfassung**

Die Erfindung sieht ein Verfahren zur Herstellung einer verbesserten organischen lichtemittierenden Diode (1) mit strukturierter Leuchtfläche und einer Unterlage (2) vor, welches die Schritte umfaßt:
- Aufbringen einer ersten leitfähigen Elektrodenschicht (5),
- Aufbringen einer Widerstandsschicht (7) mit zumindest einer Struktur (17),
- Aufbringen mindestens einer Schicht (11) mit einem organischen, elektrolumineszenten Material, und
- Aufbringen einer zweiten leitfähigen Elektrodenschicht (13), wobei die Oberfläche der Struktur (17) insbesondere in deren Randbereich (27) einen Winkel zur Oberfläche der Unterlage einnimmt, der kleiner als 90° bleibt.

## Beschreibung

Die Erfindung betrifft im allgemeinen ein Verfahren zur Herstellung organischer lichtemittierender Dioden und eine organische lichtemittierende Diode (OLED). Insbesondere betrifft die Erfindung organische lichtemittierende Dioden mit strukturierter Leuchtfläche, sowie ein Verfahren zur Herstellung solcher Dioden.

Im allgemeinen sind OLEDs aus einem Schichtverbund, beziehungsweise einer Schichtstruktur mit einer organischen elektrolumineszenten Schicht zwischen zwei Elektrodenschichten aufgebaut, der auf einem geeigneten Substrat aufgebracht ist. Im allgemeinen wirkt bei einer OLED jeweils eine der leitfähigen Schichten als Kathode und die andere als Anode. Es ist dazu bekannt, die Elektrodenschichten aus Materialien mit unterschiedlichen Austrittsarbeiten herzustellen, so daß sich zwischen diesen Schichten eine Austrittsarbeitsdifferenz ausbildet.

Organische lichtemittierende Dioden, (OLEDs) zeichnen sich gegenüber anderen Leuchtmitteln durch besondere Vorzüge aus. So besitzen OLEDs vielversprechende Eigenschaften für Flachbildschirme, da sie beispielsweise gegenüber LCD-, beziehungsweise Flüssigkristall-Anzeigen einen deutlich größeren Sichtwinkel ermöglichen und als selbstleuchtende Displays im Vergleich zu den von hinten beleuchteten LCD-Anzeigen auch einen reduzierten Stromverbrauch ermöglichen. Zudem lassen sich OLEDs als dünne, flexible Folien herstellen, die sich besonders für spezielle Anwendungen in der Licht- und Anzeigetechnik eignen.

OLEDs sind jedoch nicht nur für Displays geeignet. Allgemein können sie als Leuchtmittel für verschiedenste Anwendungen, wie etwa für selbstleuchtende Hinweisschilder und Informationstafeln eingesetzt werden.

Die überwiegende Anzahl solcher Anwendungen erfordert jedoch strukturierte Leuchtflächen. Dementsprechend müssen auf der Leuchtfläche lokale ortsfeste Helligkeitsunterschiede erzeugt werden. Dazu gibt es prinzipiell folgende Möglichkeiten:
- das emittierte Licht wird durch lateral strukturiertes Ausblenden oder Filtern direkt moduliert. Dazu kann eine OLED beispielsweise Blenden, Lochmasken, opake oder farbige Beschichtungen oder Folien auf der Außenseite der OLED, absorptive oder andersfarbige Bereiche des Substrats auf der Außen- oder Innenseite aufweisen.
- das emittierte Licht wird indirekt moduliert, indem die lokale Stromdichte durch die organische elektrolumineszente Schicht beeinflußt wird. Dies ist beispielsweise möglich durch eine entsprechende laterale Strukturierung der Elektroden. Auch eine Unterbrechung des Stromflusses durch das Schichtsystem des OLED-Schichtverbundes durch zusätzlich im Schichtverbund vorhandene Isolatorstrukturen oder Strukturen mit höherem Widerstand.
- Außerdem kann auch die elektrolumineszente Schicht selbst lateral strukturiert werden.

Eine lokale direkte Modulation des Lichtflusses wird verbreitet bei der Herstellung von LCD- oder OLED-Displays eingesetzt, bei denen ein breitbandiges Lichtspektrum, vorzugsweise weißes Licht, durch zusätzliche Farbfilter im Lichtweg auf die gewünschten Farborte zugeschnitten wird. Zusätzlich benötigt die Flüssigkristall-Technologie polarisiertes Licht, das durch entsprechende Filterung des einfallenden Lichts mittels Polarisationsfolien bedingt wird. Nachteilig ist hier, daß das Licht erst erzeugt werden muß, um dann anschließend vor dem Austritt aus dem Bauteil wieder teilabsorbiert zu werden. So wird bei den LCD-Backlight-Displays 60 % des erzeugten Lichts innerhalb des Displays allein in den Polarisationsfolien wieder absorbiert.

Die Strukturierung der elektrolumineszenten Schicht andererseits benötigt spezielle Fertigungstechologien. Beispielsweise werden aufdampfbare organische Elektrolumineszenzmaterialien mit Molekulargewichten < 1000 amu, sogenannte "Small Molecules" durch Aufdampfen über Schattenmasken im PVD-Prozess strukturiert abgeschieden. Dabei wird allerdings ein Großteil des sehr teuren elektrolumineszenten Materials nicht auf dem Substrat, sondern auf den Schattenmasken abgeschieden. Generell besteht außerdem bei einer derartigen Strukturierung das Problem, daß es aufgrund von Abschattungseffekten und damit teilweise fehlender dielektrischer Elektrolumineszenzschicht zu Kurzschlüssen zwischen den Elektrodenschichten kommen kann, deren Vermeidung erheblich komplexere Schichtstrukturen und damit kostenaufwendigere Herstellungen erfordern.

Einfacher ist demgegenüber die Strukturierung der Elektroden, beziehungsweise der Elektrodenschichten, z.B. durch das strukturierte Abscheiden der Elektrodenmaterialien mittels Schattenmaskentechniken in PVD-Verfahren. Auch hier besteht allerdings die Gefahr von Kurzschlüssen an den scharfkantigen Rändern der Elektrodenstrukturen. Ein weiterer Nachteil besteht darin, daß bei dieser Technik alle Strukturen der Elektrodenschichten elektrisch leitend miteinander verbunden sein müssen. Dieses Problem läßt sich nur unvollkommen dadurch lösen, daß leitende Brücken zwischen isolierten Strukturen einer Elektrodenschicht gezogen werden. Diese stören das Erscheinungsbild, leuchten eventuell sogar selbst und die Stromdichte durch eine Brücke ist wesentlich höher als durch flächige Strukturen, so daß ein beträchtlicher Spannungsabfall über einer Brücke entsteht, was seinerseits eine inhomogene Beleuchtung mit sich bringen kann.

Am einfachsten ist demgegenüber das Aufbringen zusätzlicher isolierender Strukturen in den OLED-Schichtverbund. Mögliche Fertigungsverfahren sind das Aufdampfen durch Schattenmasken oder strukturierte Klebefolien. Aufdampfen, Sputtern oder andere PVD-Verfahren sind als Vakuumprozesse jedoch aufwendig und kostenintensiv. Klebefolien weisen andererseits Dicken im Bereich von typischerweise 10 µm auf und sind damit im allgemeinen wesentlich dicker als die Schichten des OLED-Schichtverbundes, die im Bereich von oft nur 0,1 µm liegen. Die Folien stören damit das Gefüge der OLED-Schichtstruktur erheblich.

In der WO 9803043 wird ein Verfahren vorgeschlagen, bei welchem zur Herstellung einer strukturierten Leuchtfläche eine strukturierte Isolatorschicht photolithographisch aufgebracht wird. Dazu wird beispielsweise eine Photomaske mittels eines Druckers erzeugt. Auf das mit einer Indium-Zinn-Oxidschicht beschichtete Substrat wird ein Photolack aufgetragen, der dann durch die Maske belichtet und entwickelt wird. Das auf der Leuchtfläche wiederzugebende Muster kann bei diesem Verfahren also nicht direkt auf das Substrat übertragen werden. Vielmehr muß das wiederzugebende Muster in mehreren Zwischenschritten auf dem Substrat erzeugt werden. Beim Erzeugen von Mustern in Photolack mittels Photolithographie ergibt sich noch ein weiterer Nachteil. Die Kanten der Lackstrukturen sind wiederum sehr scharf. Dies erhöht die Gefahr von Kurzschlüssen. Besonders nachteilig ist insbesondere auch, daß es aufgrund der scharfkantigen Strukturen auf einer Unterlage beim Aufbringen nachfolgender Schichten mittels Spin-Coating oder Tauchbeschichtung zu Schlieren- und Blasenbildung in diesen Schichten kommen kann, da der Flüssigkeitsfilm an diesen Kanten zum Abreißen neigt und dessen Dicke inhomogen wird. In diesem Zusammenhang hilft auch ein nachträgliches Verrunden der Kanten, wie es in der WO 9803043 vorgeschlagen wird, nur wenig, da die inneren Kanten, die an das Substrat angrenzen, bestehen bleiben.

Ein ähnliches Verfahren wird auch in der JP 07-289988 vorgeschlagen, wo ein homogener Film aufgetragen und nachträglich durch Belichten und Entwickeln strukturiert wird, wobei als Ergebnis ein strukturierter Polyurethan-Film auf der Elektrodenschicht erhalten wird. Das in dieser Druckschrift beschriebene Verfahren weist dementsprechend ähnliche Nachteile auf, wie das in der WO 9803043 offenbarte Herstellungsverfahren.

In der US 5660573, sowie der US 3201633 werden ferner elektrolumineszente Kondensatoren beschrieben, bei welchen die lokale Helligkeit ebenfalls durch eine strukturierte dielektrische Zwischenschicht beeinlußt wird. Die Beeinflussung der Helligkeit geschieht in diesem Fall allerdings nicht durch eine Unterbrechung eines fließenden Stroms, sondern durch Beeinflussung der lokalen Feldstärke mittels einer lateralen Variation der Dielektrizitätskonstante.

Ein elektrolumineszenter Kondensator weist allerdings gegenüber einer organischen lichtemittierenden Diode gravierende Nachteile auf. Die Lichtausbeute ist deutlich schlechter. Außerdem erfordert der Betrieb eines elektrolumineszenten Kondensators hochfrequenten Wechselstrom, um eine hinreichend starke Anregung des elektrolumineszenten Materials zu erreichen. Dieser ist wesentlich schlechter bereitzustellen, verglichen mit der zum Betrieb einer OLED geeigneten Niedervolt-Gleichspannung. Zudem führt die hochfrequente Wechselspannung an den großflächigen Elektroden zu einer starken Abstrahlung elektromagnetischer Felder, bzw. starker Effizienzreduktion der Bauelemente durch Blindleistungsverluste.

Der Erfindung liegt somit die Aufgabe zugrunde, eine kostengünstig und einfach herzustellende, verbesserte OLED bereitzustellen, die eine strukturierte Leuchtfläche aufweist.

Diese Aufgabe wird bereits in höchst überraschender Weise durch ein Verfahren zur Herstellung einer OLED gemäß Anspruch 1, sowie eine OLED gemäß Anspruch 34 gelöst. Vorteilhafte Weiterbildungen sind Gegenstand der jeweiligen Unteransprüche.

Dementsprechend sieht die Erfindung ein Verfahren zur Herstellung einer organischen lichtemittierenden Diode mit einer Unterlage vor, welches die Schritte umfaßt:
- Aufbringen einer ersten leitfähigen Elektrodenschicht,
- Aufbringen wenigstens einer Widerstandsschicht mit zumindest einer Struktur,
- Aufbringen mindestens einer Schicht mit einem organischen, elektrolumineszenten Material, und
- Aufbringen einer zweiten leitfähigen Elektrodenschicht.
Dabei wird die Widerstandsschicht so aufgebracht, daß die Oberfläche der Struktur insbesondere in deren Randbereich einen Winkel zur Oberfläche der Unterlage einnimmt, der kleiner als 90° bleibt.

Eine erfindungsgemäße organische lichtemittierende Diode, die insbesondere mit dem erfindungsgemäßen Verfahren herstellbar ist, umfaßt demgemäß,
- eine Unterlage,
- eine auf der Unterlage aufgebrachte erste leitfähige Elektrodenschicht,
- mindestens eine Schicht mit einem organischen, elektrolumineszenten Material, und
- eine zweite leitfähige Elektrodenschicht, sowie
- eine wie oben beschriebene Widerstandsschicht mit zumindest einer Struktur, mit einer Oberfläche, die insbesondere in deren Randbereich einen Winkel zur Oberfläche der Unterlage einnimmt, der kleiner als 90° bleibt.

Die strukturierte Widerstandschicht kann zur Erzielung ihrer Winkung an jeder Stelle innerhalb des Schichtverbunds zwischen den beiden Elektroden aufbebracht werden, beziehungsweise angeordnet sein. Vorteilhaft ist jedoch insbesondere die Aufbringung der Schicht als erste Schicht nach der ersten leitfähigen Elektrode, da hier die Herstellungsprozedur und Schichtstrukturierung besonders einfach und kostengünstig durchzuführen sind.

Die Struktur der Widerstandsschicht ist nach dem Fertigstellen der OLED-Schichtstruktur zwischen der ersten und zweiten Elektrodenschicht angeordnet und führt dadurch zu einer Reduzierung des Stromflusses durch die Schicht mit dem elektrolumineszenten Material im Bereich der Struktur. Die Schicht mit dem organischen, elektrolumineszenten Material wird im folgenden der Einfachheit halber auch als elektrolumineszente Schicht bezeichnet.

Als organisches, elektrolumineszentes Material für die elektrolumineszente Schicht sind eine Vielzahl, dem Fachmann bekannter Substanzen einsetzbar. Unter anderem können dazu, metall-organische Materialien, insbesondere metall-organische Komplexe wie Triplett-Emitter oder Lanthanid-Komplexe verwendet werden. Beispielsweise sind "Small molecules", also Moleküle mit niedrigem Molekulargewicht, oder auch Polymermaterialien als elektrolumineszentes Material geeignet und werden vielfach für die Herstellung von OLEDs verwendet. Elektrolumineszente "Small molecules", wie z.B. Tris-(8-hydroxyquinolino)-Aluminium (Alq₃) werden dabei zumeist durch PVD-Verfahren abgeschieden. Elektrolumineszente Polymermaterialien, wie z.B. (Poly(2-methoxy, 5-(2'-ethylhexyloxy) paraphenylen vinylen (MEH-PPV) werden typischerweise aus der Flüssigphase oder über Druckprozesse abgeschieden. Die Schicht kann auch eine organische oder anorganische Matrixschicht umfassen, welche mit Emittern, wie etwa Fluoreszenzfarbstoffen als organisches, elektrolumineszentes Material dotiert sind.

Weitere elektrolumineszente Substanzen sind dem Fachmann bekannt und beispielsweise in US 6,107,452, EP 0 573 549, EP 800563 A1, EP 800563 B1 und EP 1006169 A1 beschrieben, welche durch Bezugnahme vollständig in die vorliegende Anmeldung mit aufgenommen werden. Obwohl dem Fachmann bekannt, sei auch auf den Aufbau der OLED-Schichtstruktur der in diesen Schriften beschriebenen OLEDs hingewiesen und diese Beschreibung als Inhalt dieser Anmeldung vorausgesetzt.

Als OLED-Schichtstruktur oder Schichtverbund wird im Sinne dieser Erfindung die Schichtstruktur aus den leitfähigen Elektrodenschichten und mindestens einer zwischen diesen angeordneten elektrolumineszenten Schicht bezeichnet. Neben dieser mindestens einen elektrolumineszenten Schicht können auch noch weitere Schichten zwischen den Elektrodenschichten angeordnet sein, wie beispielsweise Elektroneninjizierende und Lochinjizierende Schichten oder Loch- bzw.

Elektronentransportierende oder blockierende Schichten. Die zwischen den Elektrodenschichten angeordnete Widerstandsschicht ist somit ebenfalls Bestandteil des OLED-Schichtverbundes.

Üblicherweise werden Schichten der OLED auf die erste Elektrode, wie insbesondere die organische elektrolumineszente Schicht aufgebracht. Besonders bevorzugt kann im Rahmen der Erfindung jedoch zumindest eine weitere Schicht, wie insbesondere eine Transportschicht oder induzierende Schicht, bzw. die Schicht mit einem organischen, elektrolumineszenten Material durch Flüssigbeschichtung aufgetragen werden. Dementsprechend ist bei einer bevorzugten Ausführungsform der Diode zumindest eine auf der ersten leitfähigen Elektrodenschicht aufgebrachte Schicht, insbesondere die Schicht mit einem organischen, elektrolumineszenten Material eine durch Flüssigbeschichtung hergestellte Beschichtung.

Als Flüssigbeschichtung sind beispielsweise das Spin-Coaten, sowie auch insbesondere das Tauchbeschichten geeignet. Eine derartige durch Flüssigbeschichtung aufgetragene und anschließend verfestigte Schicht weist gegenüber einer aufgedampften Schicht vielfältige Vorzüge auf. Mittels Flüssigbeschichtung lassen sich wesentlich kostengünstiger großflächige Beschichtungen durchführen, als dies durch Aufdampfen möglich ist. Dies gilt insbesondere für Materialien mit hohem Molekulargewicht, die aus thermischen Stabilitätsgründen in der Regel nicht über Aufdampfprozesse abgeschieden werden können. So können durch Flüssigbeschichtung beispielsweise auch Polymere mit ihren positiven Stabilitäts- und Elastizitätseigenschaften aufgetragen werden.

Erfindungsgemäß wird die Widerstandsschicht so aufgebracht, daß steile Flanken an den Rändern der Struktur vermieden werden. Insbesondere im Randbereich ist daher der Winkel der Oberfläche der Struktur zur Oberfläche der Unterlage kleiner als 90°, so daß also zur Oberfläche der Unterlage senkrechte Wände vermieden werden. Dadurch wird beispielsweise ein Abreißen des Flüssigkeitsfilms oder eine Schlierenbildung vermieden, falls eine auf die strukturierte Widerstandsschicht aufgebrachte weitere Schicht, wie etwa die elektrolumineszente Schicht mittels Flüssigbeschichtungsverfahren, wie z.B. Spin-Coating aufgebracht wird. Ebenso sind auch steile Flanken der Struktur beim nachfolgenden Tauchbeschichten nachteilig, da sie zu einer sehr inhomogenen Dickenverteilung der mit Tauchbeschichten aufgebrachten Schicht führt. Demgegenüber kann das Tauchbeschichten oder Spin-Coating, da derartige steile Flanken bei der erfindungsgemäß aufgetragenen Widerstandsschicht nicht vorhanden sind, problemlos im erfindungsgemäßen Verfahren eingesetzt werden, um zumindest eine weitere Schicht, wie eine Funktionalschicht oder insbesondere die elektrolumineszente Schicht auf der Widerstandsschicht aufzubringen.

Je flacher die Winkel der Oberfläche der Struktur zur Oberfläche der Unterlage sind, desto besser ist dies dementsprechend für die Schichtqualität nachfolgender Schichten. Es ist somit von Vorteil, wenn nicht nur zur Oberfläche der Unterlage senkrechte Oberflächenbereiche der Struktur der Widerstandsschicht vermieden werden, sondern wenn die Widerstandsschicht sogar so aufgebracht wird, daß die Oberfläche der Struktur insbesondere in deren Randbereich einen maximalen Winkel zur Oberfläche der Unterlage einnimmt, der kleiner als 80°, vorzugsweise kleiner als 60°, besonders vorzugsweise kleiner als 45° bleibt. Insbesondere ist es dabei von Vorteil, wenn der Randwinkel der Struktur in diesem Bereich liegt, da bei flüssig aufgetragenem Beschichtungsmaterial für die Widerstandsschicht der maximal auftretende Winkel der Randwinkel ist. Tritt bei der Verfestigung des Beschichtungsmaterials ein Materialschwund ein, so wird der endgültige Randwinkel nach Verfestigen der Widerstandsschicht kleiner, so daß das flüssige Beschichtungsmaterial in diesem Fall sogar einen größeren Randwinkel zur Oberfläche der Unterlage aufweisen kann, als die fertige, verfestigte Struktur.

Gemäß einer weiteren Ausführungsform der Erfindung wird die Struktur der Widerstandsschicht so aufgebracht, daß die Oberfläche der Struktur insbesondere in deren Randbereich einen Winkel zur Oberfläche der Unterlage einnimmt, der unterhalb von 10° bleibt, und/oder bei welcher der Randwinkel kleiner als 10° bleibt. Bei einer derartig flach auslaufenden Struktur kann eine besonders homogene Dicke der darauf abgeschiedenen Schichten erreicht werden.

Als besonders vorteilhaft für die Schichtqualität nachfolgend aufgebrachter Schichten hat es sich weiterhin erwiesen, wenn das Aufbringen der Widerstandsschicht so erfolgt, daß das Aspektverhältnis der Kantenzone, beziehungsweise des Randbereichs der Struktur kleiner als 1, bevorzugt kleiner als 0,58 bleibt.

Vorteilhaft wird die Widerstandsschicht so strukturiert, daß die Oberfläche der Unterlage sich in zumindest einen von der Widerstandsschicht bedeckten und zumindest einen nicht bedeckten Bereich untergliedern läßt, um eine strukturierte Leuchtfläche zu erreichen.

Hat die Widerstandsschicht einen endlichen Widerstand, so bleibt auch in einem beschichteten Bereich ein gewisser Stromfluß bestehen, so daß bei ausreichendem Spannungsabfall über der elektrolumineszenten Schicht mit dem diese Schicht immer noch mit geringerer Intensität emittieren kann. Für viele Anwendungen ist jedoch eine strukturierte Leuchtfläche ausreichend, die sich in leuchtende und nichtleuchtende Bereiche untergliedert, in Analogie zu einem Bild mit einer Farbtiefe von einem Bit.

Dementsprechend kann für diese Fälle der Widerstand der Widerstandsschicht so groß gehalten werden, daß der Stromfluß in von der Widerstandsschicht bedeckten Bereichen unterbrochen wird oder der verbleibende Spannungsabfall über der elektrolumineszenten Schicht für eine wahrnehmbare Lichtemission zu klein wird. In diesem Fall wird eine derartige Schicht im Sinne dieser Erfindung als Isolationsschicht bezeichnet. Die vorstehend genannten Bedingungen für eine Isolationsschicht sind im allgemeinen insbesondere dann erfüllt, wenn der Widerstand der Isolationsschicht größer als der Widerstand der übrigen Schichten des OLED-Schichtverbundes zwischen den Elektrodenschichten, beziehungsweise der Spannungsabfall über die Widerstandschicht größer als der Spannungsabfall über die übrigen Schichten des OLED-Schichtverbundes ist.

Um in einem Motiv auf der Leuchtfläche verschiedene Helligkeitsstufen erzeugen zu können, muß, anders als bei einer Farbtiefe von einem Bit die lokal aus der Leuchtfläche austretende Helligkeit variiert werden. Dies kann beispielsweise dadurch erreicht werden, indem die Struktur der Widerstandsschicht Bereiche mit unterschiedlichem elektrischen Widerstand in Stromflußrichtung aufweist und damit der lokale Strom durch die elektrolumineszenten Schicht variiert.

Eine Möglichkeit, dies zu erreichen, besteht beispielsweise darin, eine Widerstandsschicht mit Bereichen stufenweise unterschiedlicher Schichtdicke aufzubringen. Eine einfache Möglichkeit zu Herstellung einer derartigen Schicht ist das mehrfache Beschichten mit einem Beschichtungsmaterial der Widerstandsschicht, wobei ein Bereich um so öfter beschichtet wird, je dicker dieser sein soll, beziehungsweise je größer dessen elektrischer Widerstand in Stromflußrichtung sein soll. Vorteilhaft lässt sich dies jedoch auch in Einzelschrittbeschichtungsprozessen, wie z.B. Grautondruck oder Rasterdruck erreichen.

Gemäß einer weiteren Ausführungsform der Erfindung kann die Widerstandsschicht auch farbig sein, etwa, indem diese mit Pigmenten versehen ist. Beispielsweise kann dazu eine mehrschichtige Widerstandsschicht aufgebracht werden, deren nacheinander aufgebrachte Schichten unterschiedliche Farben und/oder Tönungen aufweisen können. Auch kann die ein- oder mehrschichtige Widerstandsschicht vorteilhaft ein Muster oder Bild aufweisen, zum Beispiel, indem die Pigmente lateral variiert werden. Das Muster oder Bild kann dabei sowohl ein-, als auch mehrfarbig sein. Dabei ist es außerdem von Vorteil, wenn die OLED so aufgebaut ist, daß die Widerstandsschicht von außen sichtbar ist. Eine derartige OLED kann so auch in ausgeschaltetem Zustand bereits Information anzeigen oder einen ästhetischen Eindruck vermitteln. Das farbige Muster kann dann auf diese Weise auch zusammen mit dem Licht der Lumineszenzschicht sichtbar sein, so daß es beispielsweise zusammen mit den leuchtenden Bereichen zum ästhetischen Eindruck oder der anzuzeigenden Information beiträgt.

Die Widerstandsschicht kann außerdem aus mehreren aufeinanderliegenden Schichten aus unterschiedlichen Schichtmaterialien zusammengesetzt sein. Dazu können die Schichten mit unterschiedlichen Schichtmaterialien auf geeignete Weise nacheinander aufgebracht werden. Die unterschiedlichen Schichtmaterialien können insbesondere jeweils unterschiedliche spezifische Widerstände oder Farben aufweisen. Auf diese Weise ist es dann möglich, durch lokal variierende Kombination der einzelnen Schichten eine noch feinere Helligkeits- oder Farbabstufung zu erreichen.

Noch eine Möglichkeit zur Erzeugung lokaler, fein abstufbarer Helligkeitsunterschiede besteht außerdem darin, eine Widerstands- oder Isolationssschicht mit einer Rasterstruktur aufzubringen. Umfaßt die Struktur der Widerstandsschicht demgemäß ein Raster, so kann über die Dichte des Rasters, beispielsweise über die Dichte oder Größe von Rasterpunkten der Widerstandsschicht der mittlere Stromfluß im Bereich des Rasters und damit die emittierte Lichtmenge eingestellt werden.

Weiterhin besteht auch die Möglichkeit, eine weitere Schicht aufzubringen, welche eine lokale Variation der Lichtabsorption aufweist, etwa, indem in der Schicht lateral variierende Pigmente vorhanden sind. Diese Schicht kann beispielsweise nach Fertigstellung der OLED-Schichtstruktur auf die Außenoberfläche der Leuchtfläche aufgebracht werden. Unter einer lokalen Variation der Helligkeit wird in diesem Zusammenhang nicht nur eine Variation der totalen Helligkeit verstanden. Vielmehr kann auch die Helligkeit spektraler Bereiche, beziehungsweise die spektrale Intensitätsverteilung des emittierten Lichts beeinflußt werden, um etwa den Farbeindruck zu verändern. Dies ist darüber hinaus nicht nur durch Absorption möglich. Die Pigmente können auch Fluoreszenzfarbstoffe umfassen, so daß die spektrale Intensitätsverteilung des emittierten Lichts verschoben wird.

Außerdem kann eine Widerstandsschicht so beschaffen sein, daß sie weitere Funktionalität aufweist. Gemäß einer Ausführungsform der Erfindung umfaßt die Widerstandsschicht auch chemisch aktive Substanzen oder Gettersubstanzen, insbesondere um eine Getterwirkung für Sauerstoff und Wasser zu erreichen und die Lebensdauer der erfindungsgemäßen OLED zu erhöhen. Geeignet als Gettersubstanzen sind dabei unter anderem P₂O₅, CuO oder Al₂O₃. Diese Substanzen können Kristallwasser in ihr Gitter aufnehmen oder chemisch binden und dienen so insbesondere als Trockenmittel.

Für das Aufbringen der strukturierten Widerstandsschicht sind verschiedene Verfahren geeignet. Unter anderem kann das Aufbringen der Widerstandsschicht das Aufbringen einer Schicht durch elektrophotographisches Beschichten umfassen, wie es etwa vom Prinzip her in einem Laserdrucker oder einem Kopierer erfolgt.

Auch das Auftragen eines fluiden Beschichtungsmaterials, wie insbesondere eines Lacks und Verfestigen des Beschichtungsmaterials ist geeignet, um erfindungsgemäße strukturierte Widerstandsschichten zu erzeugen. Das fluide Beschichtungsmaterial kann dabei so gewählt werden, daß es aufgrund der Grenzflächenspannung am Rand der Struktur oder der Strukturen nicht zur Ausbildung senkrechter Oberflächenbereiche kommt. Dies ist insbesondere dann der Fall, wenn zur Herstellung der Widerstandsschicht ein fluides Beschichtungsmaterial gewählt wird, welches das Material der Oberfläche der Unterlage benetzt, so daß sich ein spitzer Randwinkels ausbildet. Dieser Effekt kann auch bei elektrophotographischer Beschichtung vorteilhaft zum Tragen kommen, wenn das aufgebrachte Beschichtungsmaterial aufgeschmolzen wird und das geschmolzene Beschichtungsmaterial die Oberfläche der Unterlage benetzt.

Das Verfestigen des Beschichtungsmaterials kann vorteilhaft das Vernetzen und/oder Eintrocknen des Beschichtungsmaterials umfassen. Eine vernetzte Widerstandsschicht ist besonders lösungsmittelbeständig gegen Lösungsmittel von aus der Flüssigphase beispielsweise durch Tauchbeschichten oder Spin-Coating abgeschiedenen weiteren Schichten.

Das Auftragen eines fluiden Beschichtungsmaterials kann vorteilhaft durch Bedrucken mittels einem rechnergesteuertem Druckkopf, wie etwa insbesondere einem Ink-Jet-Druckkopf, Bedrucken durch Siebdruck oder Besprühen durch eine Maske erfolgen. Diese Verfahren können selbstverständlich auch miteinander kombiniert werden.

Bedingt durch die aufwendige Siebherstellung ist Siebdruck jedoch weniger geeignet, um individuelle Strukturen aufzutragen. Gemäß einer Ausführungsform der Erfindung umfaßt daher das Verfahren zur Herstellung von OLEDs, die Herstellung der Widerstandsschicht ohne die Verwendung von Siebdruck.

Das Beschichtungsmaterial kann einen Licht-härtbaren Lack, insbesondere einen UV-härtbaren Lack umfassen so daß das Verfestigen des Lacks durch Belichten erfolgen kann. Jedoch kann auf einen zusätzlichen Schritt des Belichtens und Entwickelns auf der Unterlage oder die Verwendung von Photolacken auch verzichtet werden, wenn beispielsweise ein direkt strukturierendes Auftragungsverfahren eingesetzt wird.

Das Verfestigen einer Beschichtung zur Herstellung einer strukturierten Widerstandsschicht kann vorteilhaft auch mittels eines über die beschichtete Fläche gerasterten Strahls erfolgen. So kann beispielsweise das Verfestigen einer Licht-härtbaren Lackschicht durch strukturiertes Belichten, beispielsweise mittels eines gerasterten Laserstrahls erfolgen. Durch das Verfestigen einer Beschichtung mittels eines gerasterten Strahls ist unter Zuhilfenahme einer geeigneten Rechnersteuerung des Strahls oder einer geeigneten Maske eine einfache und direkte Übertragung von Motiven auf die Widerstandsschicht und somit auf die laterale Struktur der Leuchtfläche möglich.

Für die Herstellung strukturierter Widerstandsschichten mittels strukturierter Bestrahlung, etwa mittels einem gerasterten Strahl gibt es selbstverständlich noch weitere Möglichkeiten. Geeignete Vorbeschichtungen, wie Lösungen schichtbildender Materialien, Zweikomponentengemische, Monomere oder Polymere, Sol-Gele oder Pulver können durch Flüssigauftrag, Pulverbeschichtung, Kontaktübertrag oder durch Auflegen einer Folie auf die Unterlage aufgebracht werden. Als Strahl kann allgemein, je nach Beschichtungsmaterial beispielsweise kohärentes oder inkohärentes Licht, ultraviolettes, sichtbares oder infrarotes Licht, ein Elektronenstrahl oder ein Ionenstrahl dienen. Das Verfestigen der Vorbeschichtung durch den Strahl kann neben der Vernetzung auch durch Verschmelzung, Fixierung oder Verklebung erfolgen.

Gemäß einer Ausführungsform des Verfahrens umfaßt das Aufbringen wenigstens einer Widerstandsschicht mit zumindest einer Struktur das Aufschmelzen von festem Beschichtungsmaterial, insbesondere in Form einer Vorbeschichtung. Durch das Aufschmelzen und die so eintretende kurzzeitige Verflüssigung wird in einfacher Weise eine Struktur der Widerstandsschicht mit flach abfallenden Rändern geschaffen, wenn das aufgeschmolzene Material die Unterlage benetzt. Dazu kann etwa das Aufbringen der Widerstandsschicht das Aufbringen einer Schicht durch Auftragen eines Pulvers, insbesondere eines pulverförmigen Polymers oder Lacks und das Verfestigen des Beschichtungsmaterials durch Aufschmelzen erfolgen. Das Aufschmelzen seinerseits kann erreicht werden, indem in einem Ofen, durch Bestrahlung mittels Licht, insbesondere durch Infrarot- oder Laserbelichtung, durch Mikrowellenstrahlung, Elektronen- oder Partikelstrahlung oder Induktion Energie zugeführt wird. Die Zuführung kann auch mit lokal variierender Intensität erfolgen. Auf diese Weise kann beispielsweise aus einer nicht strukturierten Vorbeschichtung eine strukturierte Widerstandsschicht hergestellt werden, indem die Vorbeschichtung lokal aufgeschmolzen und dann wieder verfestigt wird.

Außer diesen Varianten des erfindungsgemäßen Verfahrens kann die Widerstandsschicht ferner auch durch Abziehen eines Abziehbildes aufgebracht werden. Das Abziehbild kann dazu das Motiv der Leuchtfläche in negativer Form aufweisen. Ein Vorteil dieser Weiterbildung des erfindungsgemäßen Verfahrens ist unter anderem, daß sich Abziehbilder ohne großen technischen Aufwand auf einem herkömmlichen Drucker erzeugen lassen. So kann etwa ein Kunde die gewünschten Motive selbst in der Form von Abziehfolien erzeugen, welche dann zu OLEDs mit selbstleuchtender Anzeigefläche weiterverarbeitet werden. Das Abziehbild kann ebenfalls zumindest bereichsweise aufgeschmolzen werden, um eine entsprechende Struktur mit flach abfallenden Rändern zu erzeugen.

Weiterhin kann das Aufbringen der Widerstandsschicht auch das Abscheiden einer Widerstandsschicht durch Gasphasenbeschichtung, wie beispielsweise durch chemische Dampfphasenabscheidung (CVD) umfassen. Das Abscheiden mittels CVD bietet unter anderem den Vorteil, daß, ähnlich wie bei elektrophotographischer Beschichtung keine Trocknungs- oder Härtungszeiten anfallen. Außerdem können mittels CVD-Beschichtung verschiedene, insbesondere anorganische Materialien abgeschieden werden. So kann mittels CVD zum Beispiel eine SiO₂-Schicht als Isolationsschicht abgeschieden werden, die besonders aufgrund ihrer guten Isolationseigenschaften, ihrer Transparenz und Härte von Vorteil ist. Mit dieser Methode lassen sich auch verschiedene Oxide und Nitride als Widerstandsschichten abscheiden. Ähnliche Vorteile bieten auch Verfahren zur physikalischen Dampfphasenabscheidung, wie beispielsweise Aufdampfen oder Sputtern.

Noch eine weitere Variante des erfindungsgemäßen Verfahrens sieht die Strukturierung einer Photolackschicht mittels Grauton-Lithographie zur Erzeugung einer Widerstandsschicht mit flach abfallenden Flanken vor. Mit Grauton-Lithographie kann die Schicht gezielt so belichtet und entwickelt werden, daß die bei herkömmlicher Lithographie entstehenden steilen Flanken mit den oben genannten Nachteilen vermieden werden. Nicht senkrechte Flanken können jedoch auch beispielsweise, wie oben beschrieben, ohne Einsatz von Photolacken erzielt werden, so daß gemäß einer Ausführungsform der Erfindung auf Photolack als Beschichtungsmaterial verzichtet wird.

Für die Widerstandsschicht sind eine Vielzahl von Materialien geeignet, deren Wahl auch vom Beschichtungsverfahren abhängt. So kann die Widerstandsschicht neben anorganischem Material auch einen thermoplastischen oder duroplastischen Kunststoff umfassen. Diese lassen sich gut aus der Flüssigphase als Einoder Mehrkomponenten-Lackschicht auftragen. Insbesondere duroplastische Kunststoffe sind gut geeignet, da sie aufgrund ihrer vernetzten Struktur resistent gegen Lösungsmittel nachfolgend aufgebrachter Schichten des OLED-Schichtverbundes sind. Die Kunststoffe können auch mit leitfähigen Materialien dotiert sein, um eine Widerstandsschicht mit definiertem Widerstand bereitzustellen. Dazu kann die Schicht beispielsweise mit Kohlenstoff oder leitfähigen Nanopartikel versetzt sein.

Die Widerstandsschicht sollte, um die Schlierenbildung oder inhomogene Stärke weiterer aufgebrachter Schichten zu vermeiden, neben der Kantenstruktur ohne senkrechte Wandbereiche auch möglichst dünn gehalten werden. Geeignet sind insbesondere Schichtdicken in einem Bereich von 0,1 µm bis 100 µm, wobei Schichtdicken im Bereich zwischen 0,1 µm bis 10 µm bevorzugt werden. Letztendlich hängt die Wahl der Schichtdicke aber insbesondere von dem lokal zu erzielenden Widerstand und dem Material der Widerstandsschicht ab.

Für viele Anwendungen ist es besonders vorteilhaft, wenn das Aufbringen der zumindest einen Struktur der Widerstandsschicht individuell rechnergesteuert erfolgt. Dies ist beispielsweise der Fall, wenn die Widerstandsschicht mit einem rechnergesteuerten Druckkopf, wie beispielsweise einem für diesen Zweck angepaßten Tintenstrahl-Druckkopf auf die Unterlage aufgetragen wird, oder wenn ein Laserstrahl oder eine Leuchtenlinie oder -array, wie zum Beispiel eine LED-Leuchtzeile rechnergesteuert moduliert einen lichthärtbaren Lack belichtet oder eine geeignete Vorbeschichtung verfestigt und so fixiert.

Auch ein elektrophotographisches Verfahren, wie es in analoger Weise zur Beschichtung von Papier in einem Laserdrucker durchgeführt wird, ist geeignet, um eine individuell gemusterte oder strukturierte Widerstandsschicht aufzutragen. Durch die rechnergesteuerte Beschichtung oder Strukturierung wird es so möglich, in einfacher Weise OLEDs mit individuell strukturierten Leuchtflächen zu erzeugen. Dies kann beispielsweise dazu eingesetzt werden, wenn die OLEDs jeweils kundenspezifisch angepaßt werden müssen. Beispielsweise kann so ein an die Kundenwünsche angepaßter Satz von Hinweisschildern erzeugt werden, von denen viele oder sogar jedes ein unterschiedliches Motiv zeigen.

Die Reihenfolge der Verfahrensschritte des Aufbringens einer ersten leitfähigen Elektrodenschicht, des Aufbringens einer Widerstandsschicht mit zumindest einer Struktur, des Aufbringens einer elektrolumineszenten Schicht und des Aufbringens einer zweiten leitfähigen Elektrodenschicht bestimmt den Schichtaufbau einer erfindungsgemäßen OLED. Dementsprechend kann die Reihenfolge auch variiert werden, wobei sinnvollerweise die Abfolge der Schritte so ist, daß die elektrolumineszente Schicht zwischen der ersten und zweiten leitfähigen Elektrodenschicht angeordnet ist, so daß ein Strom durch diese Schicht durch Anlegen einer Spannung zwischen den Elektrodenschichten fließen kann.

Bei einer bevorzugten Ausführungsform des Verfahrens wird jedoch auf der Unterlage zuerst die erste leitfähige Elektrodenschicht und die Widerstandsschicht dann auf die mit der ersten leitfähigen Elektrodenschicht beschichtete Unterlage aufgebracht. Die Schichtabfolge lautet bei dieser Ausführungsform also Unterlage / erste leitfähige Elektrodenschicht / Widerstandsschicht / Schichtpaket mit mindestens einer elektrolumineszenten Schicht/ zweite leitfähige Elektrodenschicht.

Eine der leitfähigen Elektrodenschichten ist vorteilhaft transparent oder teilweise transparent für das von der elektrolumineszenten Schicht erzeugte Licht. Dementsprechend umfaßt eine Ausführungsform des erfindungsgemäßen Verfahrens das Aufbringen einer transparenten oder teilweise transparenten Elektrodenschicht. Dabei kann sowohl die erste, als auch die zweite, oder auch beide Elektrodenschichten zumindest teilweise transparent sein.

Für sichtbares Licht sind dazu transparente leitfähige Oxide (TCO), wie beispielsweise Indium-Zinn-Oxid oder Zinnoxid, als Schichtmaterial geeignet. Aber auch an sich nicht transparente Materialien, wie insbesondere Metalle, beispielsweise Gold oder Silber können bei hinreichend kleiner Schichtdicke oder durch geeignete Strukturierung, zum Beispiel nach Art einer Lochmaske transparent oder teilweise transparent für das emittierte Licht sein.

Bei der Verwendung transparenter leitfähiger Materialien, wie Indium-Zinn-Oxid oder dünner metallischer Schichten ergibt sich zumeist das Problem, daß diese Schichten einen relativ hohen elektrischen Widerstand aufweisen. Dies kann über längere Strecken zu einem Spannungsabfall entlang der transparenten Schicht und damit zu unerwünschten lateralen Helligkeitsschwankungen führen. Außerdem fällt in dieser Schicht über den Schichtwiderstand Leistung ab, was die Effizienz herabsetzt und zu zusätzlicher Wärmeentwicklung führt. Diese Effekte können wirkungsvoll dadurch gemindert werden, indem entlang zumindest einem von der Widerstandsschicht bedeckten Bereich eine hoch leitfähige, insbesondere metallische Struktur ausgebildet wird, welche in Kontakt mit einer der leitfähigen Schichten, insbesondere mit einer transparenten leitfähigen Elektrodenschicht ist. Die leitfähige Struktur sorgt für eine gute Verteilung der fließenden Ströme und verringert so einen Spannungsabfall über die Widerstandsschicht. Die Struktur kann beispielsweise seinerseits die Form einer leitfähigen, strukturierten Schicht haben.

Gemäß einer Variante dieser Ausführungsform wird dabei die leitfähige Struktur auf der zur Schicht mit dem organischen, elektrolumineszenten Material weisenden Seite der leitfähigen Schicht angeordnet. Die hoch leitfähige Struktur kann dabei von der Widerstandsschicht bedeckt sein.

Gemäß einer weiteren Variante ist die hoch leitfähige Struktur auf der der Schicht mit dem organischen, elektrolumineszenten Material abgewandten Seite der Elektrodenschicht angeordnet. Auch hier kann der Bereich der hochleitfähigen Struktur auf der der elektrolumineszenten Material zugewandten Seite der Elektrodenschicht von der Widerstandsschicht bedeckt sein.

Beim üblichen Schichtaufbau einer OLED wird eine transparente Unterlage gewählt, wobei die darauf aufgebrachte Elektrodenschicht ebenfalls transparent ist. Das von der nachfolgend aufgebrachten elektrolumineszenten Schicht emittierte Licht tritt dann durch die Unterlage nach außen. Ebenso ist aber auch ein Aufbau möglich, bei welchem die zuletzt aufgebrachte Elektrodenschicht transparent für das emittierte Licht ist und das Licht entsprechend auf der der Unterlage abgewandten Seite der OLED-Schichtstruktur nach außen gelangt. Bei einem, derartigen Aufbau braucht die Unterlage nicht notwendigerweise transparent zu sein.

Für eine erfindungsgemäße OLED ergeben sich vielfältige Einsatzmöglichkeiten. Beispielsweise kann eine solche OLED als Leucht- oder Beleuchtungmittel verwendet werden. Besonders geeignet aufgrund seiner Eigenschaft als flächig leuchtendes, dünnes Element sind auch beispielsweise leuchtende Hinweis- oder Werbetafeln oder variable Hinweisschilder, etwa als Pixelanzeigen. Ebenso können sie zur Signalgebung oder zur Ambientebeleuchtung zum Beispiel im Automobil-, Schiffs- und Luftfahrtbereich, sowie auch für "white goods" im Küchenbereich eingesetzt werden.

Auch niedrigauflösende Displays, wie sie sich etwa vielfach in Taschenrechnern finden, sowie auch hochauflösende Displays lassen sich als OLED leicht in nahezu beliebiger Größe verwirklichen.

Ein weiteres Einsatzsgebiet sind demgemäß auch digitale, Plakatwände und Anzeigentafeln ("digital hoarding"), bei denen entsprechend großflächige Pixel benötigt werden.

Die Erfindung wird nachfolgend genauer anhand der beigefügten Figuren erläutert. Gleiche Bezugszeichen verweisen dabei auf gleiche oder ähnliche Teile.

Es zeigen:
- Fig. 1: eine Querschnittansicht durch eine erste Ausführungsform der Erfindung,
- Fig. 2: eine Aufsicht auf eine strukturierte Widerstandsschicht,
- Fig. 3A und 3B: vergleichende Querschnittansichten von strukturierten Widerstandsschichten mit scharfkantigen und flach abfallenden Strukturrändern,
- Fig. 4: eine Ausführungsform der Erfindung mit stufenweise variierender Schichtdicke der Widerstandsschicht,
- Fig. 5: eine Ausführungsform der Erfindung mit mehrschichtiger Widerstandsschicht,
- Fig. 6: eine Ausführungsform mit zusätzlicher Schicht zur Strukturierung der Leuchtfläche,
- Fig. 7A bis 7D: Ausführungsformen erfindungsgemäßer OLEDS mit zusätzlichen hoch leitfähigen Strukturen zur Unterstützung der Leitfähigkeit einer der Elektrodenschichten, und
- Fig. 8 bis 10: Ausführungsformen einer Vorrichtung zur Herstellung einer erfindungsgemäß strukturierten Widerstandsschicht,

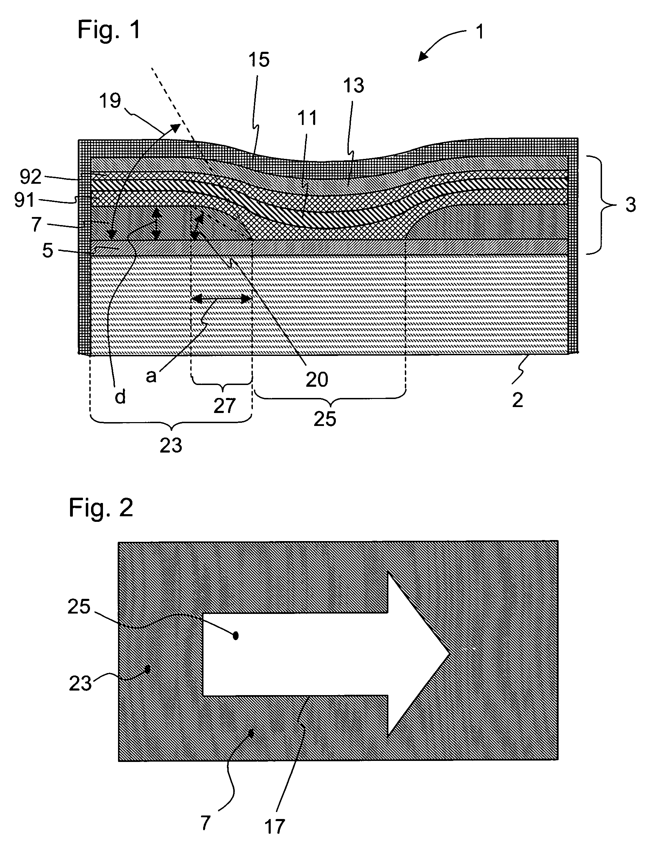

Fig. 1 zeigt eine schematische Querschnittansicht durch eine erste Ausführungsform einer erfindungsgemäßen OLED, die als Ganzes mit dem Bezugszeichen 1 bezeichnet ist. Die OLED 1 umfaßt eine Unterlage, auf der die als Ganzes mit 3 bezeichnete OLED-Schichtstruktur aufgebracht ist. Die Schichtstruktur umfaßt eine erste leitfähige Elektrodenschicht 5, welche auf die Oberfläche der Unterlage aufgebracht ist, eine auf die Elektrodenschicht 5 aufgebrachte strukturierte Widerstandsschicht 7, eine elektrolumineszente Schicht 11 und weitere funktionelle Schichten 91, 92, sowie eine abschließend aufgebrachte zweite leitfähige Elektrodenschicht 13.

Als funktionelle Schichten sind beispielsweise eine Potentialanpassungsschicht, eine Lochinjektionsschicht, eine Elektronenblockerschicht, eine Lochblockerschicht, eine Elektronleiterschicht, sowie eine Elektroneninjektionsschicht geeignet, um die Lichtausbeute zu verbessern.

Um die OLED-Schichtstruktur 3 vor schädlichen Einwirkungen zu schützen, ist die Schichtstruktur außerdem von einer Verkapselung 15 umgeben. Diese schützt empfindliche OLED-Schichten insbesondere vor atmosphärischen Bestandteilen, wie Wasserdampf und Sauerstoff, welche mit den Schichten reagieren können und zu einer Verkürzung der Lebensdauer der OLED 1 führen.

Bevorzugt ist die Unterlage und die erste leitfähige Elektrodenschicht 5 transparent oder zumindest teilweise transparent für das von der elektrolumineszenten Schicht 11 emittierte Licht. Die erste leitfähige Schicht kann dazu beispielsweise eine Indium-Zinn-Oxidschicht oder eine dünne transparente Metallschicht sein. Das Licht kann so die Unterlage durchqueren und auf der gegenüberliegenden Seite der Unterlage austreten.

Es ist aber auch ein inverser OLED-Schichtaufbau möglich. In diesem Fall ist die zweite leitfähige Elektrodenschicht 13 transparent und das Licht tritt durch die Verkapselung 15 nach außen, für die dann zur Herstellung der OLED 1 ebenfalls ein transparentes Material zu wählen ist. Die Unterlage 2 braucht in diesem Fall nicht transparent zu sein. Selbstverständlich ist jedoch auch eine beidseitig leuchtende OLED herstellbar, bei welcher das Licht sowohl durch die Verkapselung 15, als auch durch das Substrat nach außen gelangen kann und wobei beide Elektrodenschichten 5 und 13 zumindest teilweise transparent sind.

Die Widerstandsschicht 7 ist in der einfachsten Form als Isolationsschicht ausgeführt, welche den Stromfluß zwischen Anode und Kathode, beziehungsweise zwischen den leitfähigen Elektrodenschichten 5, 13 unterbricht.

Die Widerstandsschicht 7 ist in der in Fig. 1 dargestellten Ausführungsform dabei derart strukturiert, daß sie die Oberfläche der Unterlage 2 in zumindest einen von der Widerstandsschicht 7 bedeckten Bereich 23 und zumindest einen nicht bedeckten Bereich 25 untergliedert. Fig. 2 zeigt in Aufsicht ein Beispiel für eine solche strukturierte Widerstandsschicht. Diese umfaßt eine Struktur 17 in Form eines negativen Blockpfeils, so daß der Bereich 25 des Blockpfeils nicht von der Widerstandsschicht 7 bedeckt ist. Dieser Bereich 25 bildet dann einen leuchtenden Bereich der Leuchtfläche der erfindungsgemäßen OLED.

Der Randbereich 27 der Struktur 17 ist in Fig. 1 angedeutet. Der Randbereich wird durch den Bereich definiert, innerhalb welchem die mit der Schichtdicke d aufgebrachte Widerstandsschicht zum Rand der Struktur 17 abnimmt.

Die Oberfläche der Struktur der Widerstandsschicht 7 nimmt insbesondere in deren Randbereich 27 einen Winkel zur Oberfläche der Unterlage ein, der kleiner als 90° bleibt. Der Randbereich der in Fig. 1 gezeigten Ausführungsform weist eine abgerundete Struktur mit einem Randwinkel 19 auf. Der Randwinkel, welcher bei diesem abgerundeten Randbereich der größte auftretende Winkel der Oberfläche der Struktur zur Oberfläche der Unterlage 2 ist, beträgt bei dieser Ausführungsform sogar nur etwa 60 Grad.

Der Randbereich 27 der Widerstandsschicht läuft außerdem zum Rand 29 hin so flach aus, daß das Aspektverhältnis des Randbereichs 27 kleiner als 1 bleibt. Als Aspektverhältnis wird im Sinne dieser Erfindung das Verhältnis der Schichtdicke d der Widerstandsschicht 7 zur Breite a des Randbereiches 27 verstanden. Dieses entspricht somit auch dem Tangens des mittleren Steigungswinkels 20 der Oberfläche des Randbereichs 27. Bei der in Fig. 1 dargestellten Ausführungsform ist das Aspektverhältnis sogar etwas kleiner als 0,58, was einem mittleren Steigungswinkel von 30 Grad entspricht.

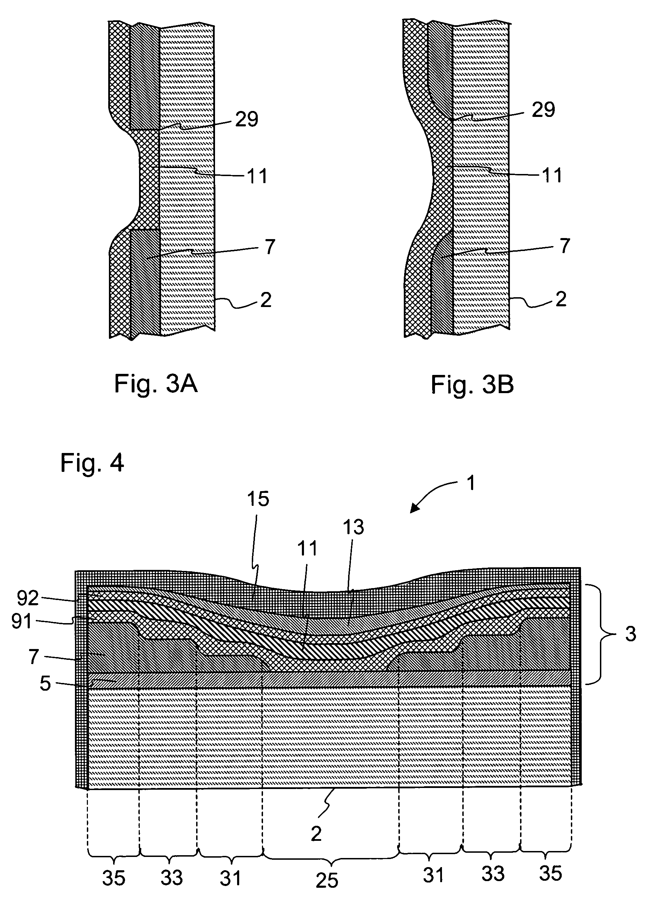

Die Fig. 3A und 3B zeigen anhand von Querschnittansichten einen Vergleich von strukturierten Widerstandsschichten 7 mit scharfkantigen und erfindungsgemäß flach abfallenden Strukturrändern. Dabei zeigt Fig. 3A ein mit einer strukturierten Widerstandsschicht 7 beschichtete Unterlage 2, bei welcher die Ränder oder Flanken der Struktur scharfkantig und im wesentlichen senkrecht sind. Derartige Strukturen entstehen typischerweise bei einer photolithographischen Strukturierung. Eine nachfolgend aufgebrachte Schicht, wie hier beispielhaft eine elektrolumineszente Schicht 11 besitzt im Bereich der Kanten der Struktur eine deutlich reduzierte Schichtdicke. Dies führt zu einer starken Deformation der gesamten Schichtstruktur der OLED. Weiter kann der Strömungswiderstand der steilen Kante im Falle einer Beschichtung aus der Flüssigphase zu Schlierenbildung und lateralen Inhomogenitäten der Schichtdicke führen.

Demgegenüber weicht die Schichtdicke der Schicht 11 bei einer erfindungsgemäß strukturierten Widerstandsschicht, wie sie Fig. 3B zeigt, auch im Kantenbereich nur wenig von der Schichtdicke in anderen Bereichen ab. Die flach abfallenden Kanten der erfindungsgemäßen Widerstandsschicht sorgen außerdem für eine bessere Benetzbarkeit insbesondere auch im Bereich des Randes 29 der Strukturen der Widerstandsschicht 7 durch nachfolgende Schichten. Dadurch wird besonders bei Spin-Coating oder Tauchbeschichtung Schlieren- und Blasenbildung unterdrückt.

Die Vorteile der Erfindung sind um so größer, je flacher der Randbereich 27 zum Rand 29 hin ausläuft, oder, je flacher der Winkel der Oberfläche der Widerstandsschicht zur Oberfläche der Unterlage bleibt. Gemäß einer Ausführungsform der Erfindung ist daher ein maximaler Steigungswinkel oder ein Randwinkel der Struktur vorgesehen, der kleiner als 10° ist.

Fig. 4 zeigt eine Querschnittansicht durch eine weitere Ausführungsform der Erfindung, bei welcher die Struktur 27 der Widerstandsschicht 7 Bereiche 31, 33 und 35 mit unterschiedlicher Schichtdicke aufweist. Die in Fig. 4 gezeigte Ausführungsform weist dabei beispielhaft Bereiche mit drei verschiedenen Schichtdicken auf. Der durch die OLED-Schichtstruktur lokal zwischen den Elektrodenschichten 5 und 13 fließende Strom und damit die Helligkeit des lokalen Bereichs ist dabei von dem Widerstand der Widerstandsschicht in Stromflußrichtung abhängig, der wiederum mit steigender Schichtdicke wächst. Dementsprechend wird die Leuchtfläche im Bereich 35 am wenigsten und im Bereich 25 am meisten Licht abgeben.

Zusammen mit dem nicht beschichteten Bereich 25 läßt sich mit den beispielhaft in Fig. 4 gezeigten drei Bereichen 31, 33, 35 mit unterschiedlicher Schichtdicke vier verschiedene Helligkeitsstufen der Leuchtfläche erzeugen. Dies entspricht einer Farbtiefe von 2 Bit.

Wird eine höhere Farbtiefe verlangt, so können entsprechend weitere Bereiche mit einer feineren Schichtdickenabstufung gewählt werden. Allerdings müßten, um eine Farbtiefe von 4 Bit erzeugen zu können, die Schichtdicke in sechzehn Stufen abgestuft werden können.

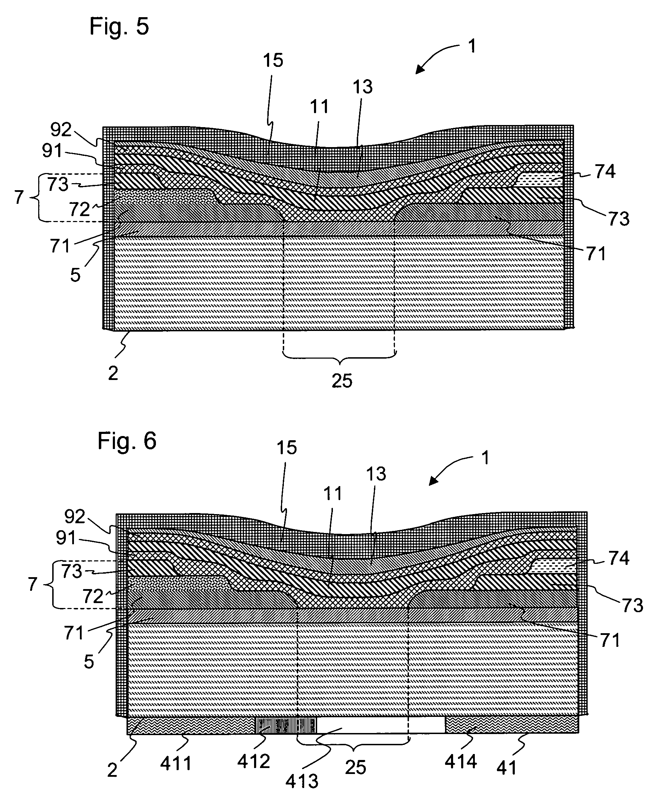

Eine große Farbtiefe läßt sich aber auch mit einer geringen Anzahl verschiedener Schichten erzeugen. Ein solches Beispiel ist in Fig. 5 dargestellt. Fig. 5 zeigt eine Ausführungsform mit mehrschichtiger Widerstandsschicht 7, bei welcher die einzelnen Schichten 71, 72, 73 und 74 unterschiedliche Schichtmaterialien aufweisen. Diese Schichtmaterialien und die Schichtdicken der einzelnenn Schichten 71 - 74 sind so gewählt, daß die einzelnen Schichten in Stromflußrichtung, die hier im wesentlichen senkrecht zur Oberfläche der Unterlage 2 verläuft, einen unterschiedlichen Widerstand aufweisen. Der Widerstand der Einzelschichten 71 - 74 wird dabei vorteilhaft analog der Wertigkeit von Bits eines Bitwortes gewählt, dessen Länge der Anzahl der verschiedenen Schichten entspricht. Bei vier verschiedenen Schichten 71 - 74 ist die Länge des Bitwortes gleich 4 und der Widerstand der Einzelschichten wird nacheinander verdoppelt. Dementsprechend kann der Widerstand der Schicht 74 doppelt so hoch wie der Widerstand der Schicht 73, der Widerstand der Schicht 73 wiederum doppelt so hoch wie der Widerstand der Schicht 72, etc., gewählt werden. Auf diese Weise kann bereits mit einer vierschichtigen Widerstandsschicht eine Farbtiefe der Leuchtfläche von 4 Bit, also von 16 verschiedenen Helligkeitsstufen erzielt werden.

Ist also beispielsweise, wie oben angegeben, der Widerstand der Schicht 74 am höchsten und der Widerstand der Schicht 71 am niedrigsten, wobei sich die Widerstände von Schicht zu Schicht jeweils halbieren, so wird in dem in Fig. 5 ganz auf der linken Seite liegenden Bereich, wo die Schichten 71, 72 und 73 aufeinanderliegen, ein Helligkeitswert von 9/16 der in Bereich 25 auftretenden Maximalhelligkeit erreicht. Im Bereich auf der rechten Seite von Fig. 5, in welchem die Schichten 71, 73 und 74 aufeinanderliegen, wird demnach ein Helligkeitswert von 3/16 der Maximalhelligkeit erreicht.

Eine andere, sehr einfache Möglichkeit, das Leuchtbild der Leuchtfläche lateral zu strukturieren, zeigt Fig. 6. Die in Fig. 6 dargestellte Ausführungsform der Erfindung weist eine weitere Schicht 41 mit einer lokal variierenden Lichtabsorption durch lateral variierende Pigmente zur lokalen Variation der Helligkeit der Leuchtfläche auf. Bei der in Fig. 6 gezeigten Ausführungsform ist die Pigmentschicht außen auf der Lichtaustrittsseite der OLED 1 aufgebracht.

Die lateral varriierende Pigmentierung der Pigmentschicht 41 ist in Fig. 6 durch unterschiedlich schraffierte Bereiche 411 bis 414 symbolisiert. Die Bereiche 411 bis 414 können dabei beispielsweise eine Pigmentierung mit unterschiedlicher Dichte aufweisen. Durch unterschiedliche Pigmentierung kann, anders als bei einer lateralen Variation des Widerstands der Widerstandsschicht 7 aber nicht nur die Helligkeit der Leuchtfläche lokal definiert werden. Die Pigmente können vielmehr auch das Farbspektrum des von der elektrolumineszenten Schicht emittierten Lichts beeinflussen, indem beispielsweise farbige oder fluoreszierende Pigmente in die Pigmentschicht eingebracht werden.

Selbstverständlich kann eine Pigmentschicht nicht nur mit einer OLED mit mehrschichtiger Widerstandschicht, wie sie in den Fig. 5 und 6 gezeigt ist, kombiniert werden, sondern auch mit allen anderen Ausführungsformen der Erfindung.

Alternativ oder zusätzlich zu der in Fig. 6 dargestellten Pigmentschicht 41 kann auch die Widerstandsschicht 7 so aufgebracht werden, daß sie ein ein- oder mehrfarbiges Muster oder Bild aufweist. Dies kann beispielsweise durch das Aufbringen einer Widerstandsschicht mit lateral variierenden Pigmenten bewerkstelligt werden.

Auch kann die Widerstandsschicht mehrschichtig aufgebracht werden, wobei die nacheinander aufgebrachten Schichten unterschiedlichen Farben oder Tönungen aufweisen können. In diesem Fall weisen die Schichten 71, 73 und 74 der in Fig. 5 und 6 gezeigten Ausführungsformen unterschiedliche Farben oder Tönungen auf, so daß sich durch deren zusätzliche laterale Strukturierung ein Muster ergibt. Die Widerstandsschicht ist bevorzugt auch von außen sichtbar, so daß sie auf diese Weise zum ästhetischen Eindruck oder Informationsgehalt beiträgt.

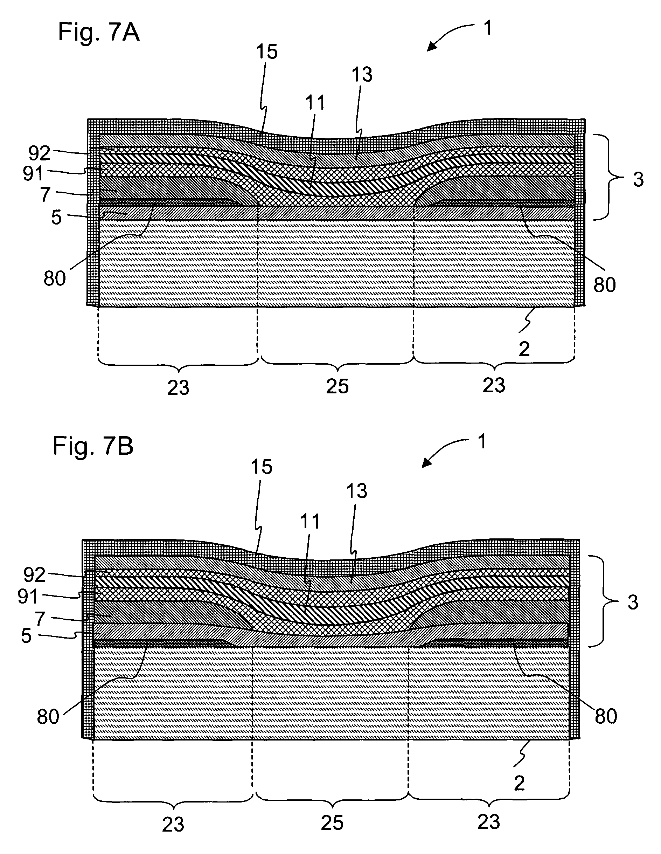

In den Fig. 7A bis 7D sind zwei weitere Ausführungsformen einer erfindungsgemäßen OLED 1 dargestellt. Diesen beiden Ausführungsformen der OLED ist gemeinsam, daß entlang einem von der Widerstandsschicht bedeckten Bereich 23 eine hoch leitfähige, vorzugsweise metallische Struktur 80 ausgebildet ist, welche in Kontakt mit der transparenten leitfähigen Elektrodenschicht 5 ist. Diese zusätzliche hoch leitfähige Struktur vermindert Spannungsabfälle entlang der im allgemeinen nur mäßig leitfähigen transparenten Elektrodenschicht 5.

Die Struktur 80 kann die Gestalt einer durchgehenden Schicht haben, die in Aufsicht auf die Leuchtfläche entsprechend der Form des Bereichs 23 ausgestaltet ist. Es sind jedoch auch andere Formen, wie beispielsweise entlang des Bereichs 23 parallel verlaufende Balken möglich.

Bei der in Fig. 7A dargestellten Ausführungsform einer OLED ist die leitfähige Struktur 80 auf der ersten leitfähigen Schicht 5 aufgebracht. Die leitfähige Struktur 80 wird dabei von der Struktur der nachfolgend aufgebrachten Widerstandsschicht 7 bedeckt. Durch diesen Aufbau ist die leitfähige Struktur 80 auf der zur elektrolumineszenten Schicht 11 weisenden Seite der leitfähigen Elektrodenschicht 5 angeordnet. Vorteilhaft kann dabei auch die hoch leitfähige Struktur so aufgebracht werden, daß die Oberfläche der leitfähigen Struktur insbesondere in deren Randbereich einen Winkel zur Oberfläche der Unterlage einnimmt, der kleiner als 90° bleibt, mit ähnlichen Vorteilen wie bei der Struktur der Widerstandsschicht. Insbesondere kann dabei der maximale Steigungswinkel im Randbereich oder an der Kante kleiner als 80°, vorzugsweise kleiner als 60°, besonders vorzugsweise kleiner als 45° gehalten werden.

Bei der in Fig. 7B dargestellten Ausführungsform ist dagegen zuerst die hoch leitfähige Struktur 80 auf der Unterlage aufgebracht. Auf die so vorbereitete Unterlage 2 wird dann die erste Elektrodenschicht und dann die weiteren Schichten der OLED aufgebracht. Dadurch ist bei dieser Ausführungsform die hoch leitfähige Struktur auf der der Schicht mit dem organischen, elektrolumineszenten Material abgewandten Seite der Elektrodenschicht 5 angeordnet.

Eine hoch leitfähige Struktur kann selbstverständlich auch alternativ oder zusätzlich zur Unterstützung der Leitfähigkeit der zweiten Elektrodenschicht 13 vorhanden sein, wobei die hoch leitfähige Struktur entsprechend wieder so angeordnet wird, daß sie sich entlang einem von der Widerstandsschicht bedeckten Bereich 23 erstreckt und in Kontakt mit der leitfähigen Elektrodenschicht 13 ist.

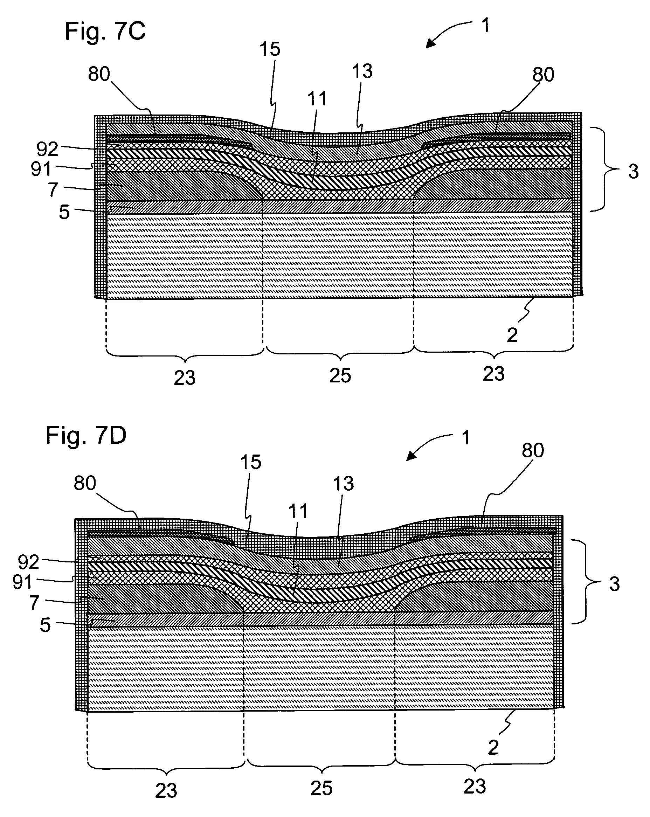

Derartige beispielhafte Ausführungsformen sind in den Fig. 7C und 7D dargestellt. Bei der in Fig. 7C gezeigten OLED befindet sich ähnlich wie bei der in Fig. 7A dargestellten Ausführungsform der Erfindung die hoch leitfähige Struktur 80 auf der der elektrolumineszenten Schicht 11 zugewandten Seite der zweiten Elektrodenschicht 13. Die in Fig. 7D gezeigte Ausführungsform weist eine auf der zweiten Elektrodenschicht 13 aufgebrachte hoch leitfähige Struktur 80 auf. Bei beiden Ausführungsformen erstreckt sich die hoch leitfähige Struktur 80 ebenfalls entlang eines von der Widerstandsschicht 7 bedeckten Bereichs 23 der Unterlage.

Die in den Fig. 7C und 7D gezeigten Aufbauten von OLEDs können besonders vorteilhaft auch für einen Lichtaustritt auf der dem Substrat gegenüberliegenden Seite ausgebildet sein, wobei in diesem Fall die zweite Elektrodenschicht 13 zumindest teilweise transparent für das von der elektrolumineszenten Schicht 11 emittierte Licht ist. Bei einem derartigen Aufbau kann vorteilhaft auch die Verkapselung wenigstens auf der Lichtaustrittsseite der OLED transparent ausgestaltet sein.

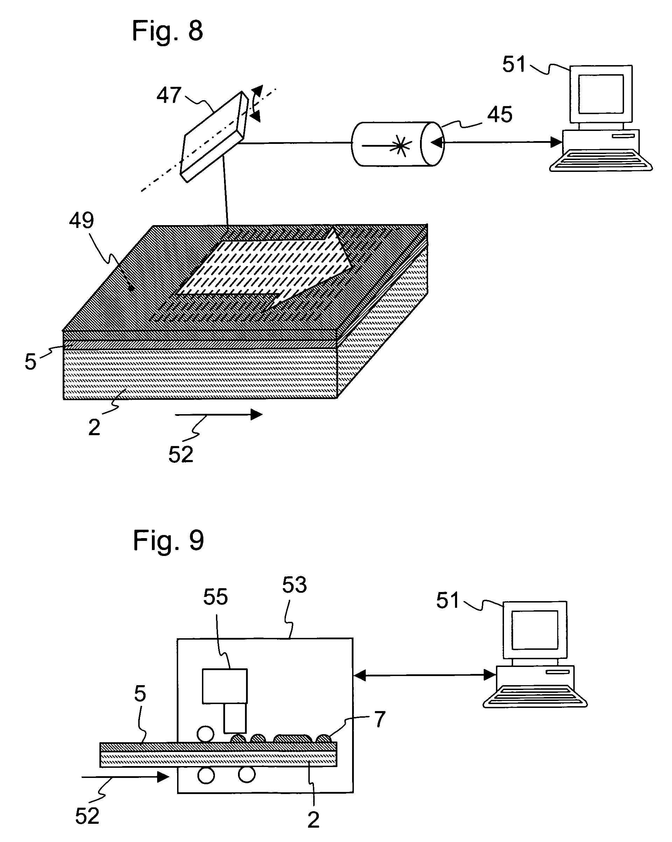

Fig. 8 zeigt eine Ausführungsform einer Vorrichtung zur Herstellung einer strukturierten Widerstandsschicht. Dazu wird auf die Unterlage 2 zunächst eine Vorbeschichtung in Form einer Lackschicht aus Licht-härtbaren Lack 49 aufgebracht. Danach wird zum Verfestigen der Lackschicht ein Laserstrahl über die beschichtete Oberfläche der Unterlage 2 gerastert. Um geeignete Strukturen, wie etwa den beispielhaft dargestellten Blockpfeil zu erzeugen, wird der Laserstrahl in Abhängigkeit vom Auftreffpunkt auf der Oberfläche moduliert werden, um die Vorbeschichtung strukturiert zu belichten. Dies geschieht, indem der Strahl lateral gezielt über die Oberfläche gerastert oder uniform gerastert und gleichzeitig entsprechend intensitätsmoduliert wird. Dazu wird die Intensität eines Lasers 45 von einer mit dem Laser verbundenen Recheneinrichtung 51 gesteuert, während der Laserstrahl durch Schwenken eines Schwenkspiegels 47 und Vorschieben der Unterlage entlang der Vorschubrichtung 52 über deren Oberfläche gerastert wird. Vorteilhaft wird auch der Schwenkspiegel und der Vorschub von der Recheneinrichtung gesteuert. An den Stellen, an denen der Laserstrahl die Oberfläche trifft und den Lack 49 belichtet tritt dann eine Verfestigung des Lacks ein. Gemäß einer weiteren Ausführungsform der Erfindung wird mittels einer Vorrichtung, wie sie in Fig. 8 gezeigt ist, eine Schicht aus festem Beschichtungsmaterial, wie etwa eine Schicht aus pulverförmigen Polymer oder Lack aufgebracht und diese dann anschließend durch Aufschmelzen verfestigt. Dabei wird die Energie zum Aufschmelzen durch den auftreffenden Laserstrahl bereitgestellt, so daß durch den gerasterten und intensitätsmodulierten Laserstrahl eine strukturierte Widerstandsschicht erzeugt werden kann. Durch die mittels Aufschmelzen erreichte Verfestigung wird außerdem insbesondere bei Benetzung der Unterlage durch das aufgeschmolzene Beschichtungsmaterial erreicht, daß die Ränder der Struktur flach auslaufen und ein Randwinkel der Widerstandsschicht zur Unterlage von kleiner als 90° entsteht.

In Fig. 9 ist schematisch eine weitere Ausführungsform einer Vorrichtung zum Aufbringen einer erfindungsgemäß strukturierten Widerstandsschicht auf eine Unterlage gezeigt. Die Vorrichtung umfaßt ebenfalls eine Recheneinrichtung 51. Die Recheneinrichtung 51 steuert eine Druckvorrichtung 53 mit einem Druckkopf 55. Als Druckkopf kann beispielsweise ein Tintenstrahl-Druckkopf verwendet werden, der mit einem geeigneten Lack als Beschichtungsmaterial befüllt wird.

Das gewünschte Motiv der Leuchtfläche der OLED kann so direkt durch die Recheneinrichtung 51 mit der mit dieser verbundenen Druckvorrichtung in Form einer strukturierten Widerstandsschicht 7 auf die Unterlage 2 übertragen werden.

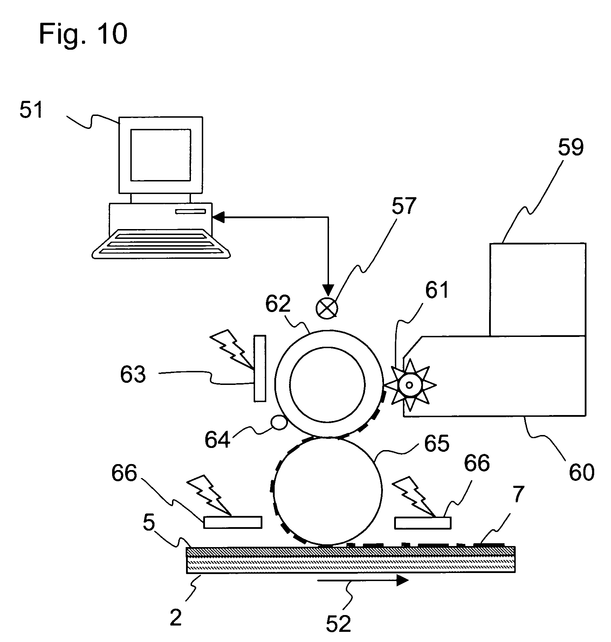

Fig. 10 zeigt noch eine weitere, bevorzugte Ausführungsform einer Vorrichtung zum Auftragen einer strukturierten Widerstandsschicht 7 auf eine Unterlage 2. Die in Fig. 10 dargestellte Ausführungsform dient speziell zur elektrophotographischen Übertragung einer Widerstands- oder Isolationsschicht auf die Unterlage. Die Funktionsweise einer solchen Vorrichtung entspricht prinzipiell der eines Laserdruckers oder Kopierers.

Eine Fotoleitertrommel 62 mit einem Trägermaterial, in der Regel eine Aluminiumtrommel, einer leitfähigen Beschichtung, einer ladungserzeugenden Schicht, einer Ladungstransportschicht und einer Verschleißschutzschicht, rotiert, wobei deren Oberfläche zunächst an einer Reinigungsund Löschlichteinheit 64 und anschließend an einem Ladekorotron 63 vorbeibewegt wird, wodurch dieses Ladung an die Fotoleitertrommel 62 abgibt und die Oberfläche der Fotoleitertrommel 62 gleichmäßig, beispielsweise negativ, auflädt.

Die aufgeladene Oberfläche der Fotoleitertrommel 62 wird dann durch deren Rotation an einem Bebilderungssystem 57, z.B. an einem LED-Array oder Lasersystem, vorbeibewegt. Diese wird wiederum von einer Recheneinrichtung 51 angesteuert, so daß die Fotoleitertrommel 62 entsprechend dem auf die Oberfläche der Unterlage 2 zu übertragenen Motiv belichtet wird. Dabei wird das Licht an den belichteten Stellen in der ladungserzeugenden Grundschicht absorbiert und positive Ladungen erzeugt, die durch die Ladungstransportschicht die Ladung an der Oberfläche der Fotoleitertrommel kompensieren, so dass auf der Fotoleitertrommel ein latentes Ladungsbild des Motivs entsteht.

Mit einer Magnetbürste 61 einer Entwicklungseinheit 60 wird dann das Isolations- bzw. Widerstandsmaterial in Form von einem Toner aus einem Tonerbehälter 59 auf die Fotoleitertrommel 62 übertragen. Zwischen der Fotoleitertrommel 62 und der Entwicklungseinheit 60 wird dazu außerdem eine Biasspannung gelegt. Der Toner haftet auf Grund des Potenzialunterschieds nur an den durch die Belichtung entladenen Bereichen der Fotoleitertrommel 62. Besteht die Unterlage aus einem vergleichsweise harten Material, wie beispielsweise aus Glas, wird der Toner vorteilhaft nicht direkt auf die Unterlage 2, sondern vielmehr von der Fotoleittrommel 62 zunächst auf eine Transfertrommel 65 und erst dann auf die Unterlage 2 übertragen. Die Transfertrommel weist eine weiche Oberfläche, wie etwa aus Gummi, Silikon oder EPDM auf, die sich der Oberfläche der Unterlage 2 gut anpassen kann, so daß ein guter Kontakt der Unterlage zum Toner auf der Transfertrommel 65 erreicht wird.

Die Unterlage wird mit einem Übertragungskorotron 66 ebenfalls gleichmäßig aufgeladen, so daß der Toner von der Transfertrommel 65 abgezogen wird. Anstelle einer Aufladung mittels eines Übertragungskorotrons 66 kann eine uniforme Aufladung auch einfach durch direkten elektrischen Kontakt mit einer Spannungsquelle erzielt werden, da die Oberfläche der Unterlage 2 aufgrund der vorangegangenen Beschichtung mit einer leitfähigen Elektrodenschicht 5 gut leitfähig ist und die Ladung sich gleichmäßig verteilt. In einem nachfolgenden Fixiervorgang wird die mit dem Toner beschichtete Oberfläche auf eine moderate Temperatur unterhalb von 250 °C, typischerweise zwischen 120 und 180 °C, erwärmt und der Toner verfestigt.

Eine weitere Verfahrensvariante der elektrophotografischen Beschichtung sieht vor, daß das Substrat 2 zuvor aufgeheizt wird, beispielsweise auf eine Temperatur von < 200 °C, vorzugsweise zwischen 100 °C und 150 °C, und danach das Widerstands- bzw. Isolationsmaterial in Form eines Toners mittels Kontakt mit der Transfertrommel 65 übertragen wird. Eine Fixierung des Toners im Anschluss an den Übertrag kann in diesem Fall entfallen. Die oben genannten Übertragungskorotrone 66 können hier ebenfalls entfallen.

Dieser Vorgang des Aufbringens einer Widerstandsschicht mit zumindest einer Struktur ist unter anderem deshalb von Vorteil, da die Beschichtung vergleichsweise schnell durchgeführt werden kann und eine Trocknungsphase entfällt.

Mit einer derartigen elektrophotographischen Beschichtung läßt sich eine laterale Auflösung der Struktur von < 100 µm, vorzugsweise < 50 µm erreichen. Es kann sowohl ein Graustufendruck mit variabler Schichtdicke, etwa mit einer Schichtdicke zwischen 1 µm und 8 µm, als auch ein Rasterdruck durchgeführt werden, um Helligkeitsabstufungen des Leuchtbildes zu erreichen. Bei Verwendung farbiger Toner können zusätzlich farbige Widerstandsschichten erzeugt werden. Durch den Fixiervorgang mit einem Aufschmelzen der Tonerpartikel kommt es insbesondere auch zu einer Verrundung des Kantenbereiches, so daß steile Flanken der Strukturen nicht auftreten.

Durch mehrfache Wiederholung des Druckvorgangs kann auch leicht eine Struktur der Widerstandsschicht so aufgebracht werden, daß sie Bereiche mit stufenweise unterschiedlicher Schichtdicke aufweist. Ebenfalls sind durch Mehrfachwiederholungen des Druckvorgangs mit unterschiedlich gefärbten Tonern Vielfarbdrucke zur Erhöhung der Funktionalität oder des ästhetischen Eindrucks der sichtbaren Widerstandsschicht möglich.

Zu Auftragen der Widerstandsschicht können neben den oben beschriebenen Non-Impact Print-Verfahren auch Verfahren zur Anwendung kommen, die eine Maske oder dergleichen benötigen. Beispiele dafür sind Siebdruck- oder Flexodruckverfahren. Eine individuelle Gestaltung der Widerstandsschicht in kleinen Auflagezahlen ist dabei aufgrund der Maskenherstellung jedoch in der Regel zeit- und kostenintensiver.

### Bezugszeichenliste

- 1: OLED
- 2: Unterlage
- 3: OLED-Schichtverbund
- 5: erste leitfähige Schicht
- 7: Widerstandsschicht
- 91, 92,...,9N: Funktionalschichten
- 11: elektrolumineszente Schicht
- 13: zweite leitfähige Schicht
- 15: Verkapselung
- 17: Struktur von 7
- 19: Randwinkel
- 20: mittlerer Steigungswinkel
- 23: bedeckter Bereich
- 25: unbedeckter Bereich
- 27: Kantenbereich, Randbereich von 17
- 29: Rand von 17
- 31, 33, 35: Bereiche von 17 mit unterschiedlicher
- 71 - 74: Schichten von 7 mit unterschiedlichen
- 41: Pigmentschicht
- 411 - 414: Unterschiedlich pigmentierte Bereiche von 41
- 45: Laser
- 47: Schwenkspiegel
- 49: Licht-härtbare Lackschicht
- 51: Recheneinrichtung
- 52: Vorschubrichtung
- 53: Druckvorrichtung
- 55: Druckkopf
- 57: Bebilderungssystem
- 59: Toner-Behälter
- 60: Entwicklungseinheit
- 61: magnetische Bürste
- 62: Fotoleittrommel
- 63: Ladekorotron
- 64: Reinigungs- und Löschlichteinheit
- 65: Transfertrommel
- 66: Übertragungskorotron
- 80: hoch leitfähige Struktur

## Patentansprüche

1. Verfahren zur Herstellung einer organischen lichtemittierenden Diode (1) mit einer Unterlage (2), welches die Schritte umfaßt:
- Aufbringen einer ersten leitfähigen Elektrodenschicht (5),
- Aufbringen wenigstens einer Widerstandsschicht (7) mit zumindest einer Struktur (17),
- Aufbringen mindestens einer Schicht (11) mit einem organischen, elektrolumineszenten Material, und
- Aufbringen einer zweiten leitfähigen Elektrodenschicht (13) ,
**dadurch gekennzeichnet, daß**
die Oberfläche der Struktur (17) insbesondere in deren Randbereich (27) einen Winkel zur Oberfläche der Unterlage einnimmt, der kleiner als 90° bleibt.

2. Verfahren nach Anspruch 1, **dadurch gekennzeichnet, daß** die Widerstandsschicht (7) so aufgebracht wird, daß die Oberfläche der Struktur (17) insbesondere in deren Randbereich (27) einen maximalen Steigungswinkel (19) zur Oberfläche der Unterlage (2) einnimmt, der kleiner als 80°, vorzugsweise kleiner als 60°, besonders vorzugsweise kleiner als 45° bleibt.

3. Verfahren nach einem der vorstehenden Ansprüche, **dadurch gekennzeichnet, daß** die Widerstandsschicht (7) so aufgebracht wird, daß der Randwinkel (19) der Struktur (17) zur Oberfläche der Unterlage (2) kleiner als 80°, vorzugsweise kleiner als 60°, besonders vorzugsweise kleiner als 45° bleibt.

4. Verfahren nach einem der vorstehenden Ansprüche, **dadurch gekennzeichnet, daß** die Widerstandsschicht (7) so aufgebracht wird, daß die Oberfläche der Struktur (17) insbesondere in deren Randbereich einen Winkel zur Oberfläche der Unterlage einnimmt, der unterhalb von 10° bleibt, oder bei welcher der Randwinkel kleiner als 10° bleibt.

5. Verfahren nach einem der vorstehenden Ansprüche,
**dadurch gekennzeichnet, daß** das Aufbringen der ersten (5) oder das Aufbringen der zweiten Elektrodenschicht (13) das Aufbringen einer transparenten oder teilweise transparenten Elektrodenschicht umfaßt.

6. Verfahren gemäß einem der vorstehenden Ansprüche,
**dadurch gekennzeichnet, daß** auf die Unterlage (2) die erste Elektrodenschicht (5) und auf die erste Elektrodenschicht (5) die zumindest eine Widerstandsschicht (7) aufgebracht wird.

7. Verfahren nach einem der vorstehenden Ansprüche, **dadurch gekennzeichnet, daß** das Aufbringen der Widerstandsschicht (7) so erfolgt, daß das Aspektverhältnis des Randbereichs der Struktur kleiner als 1, bevorzugt kleiner als 0,58 bleibt.

8. Verfahren nach einem der vorstehenden Ansprüche, **dadurch gekennzeichnet, daß** das Aufbringen der Widerstandsschicht (7) das Aufbringen einer Schicht durch elektrofotographisches Beschichten umfaßt.

9. Verfahren nach einem der vorstehenden Ansprüche, **dadurch gekennzeichnet, daß** das Aufbringen der Widerstandsschicht (7) das Aufbringen einer Schicht durch Auftragen eines fluiden Beschichtungsmaterials, insbesondere eines Lacks und Verfestigen des Beschichtungsmaterials umfaßt.

10. Verfahren nach Anspruch 9, **dadurch gekennzeichnet, daß** für die Widerstandsschicht (7) ein fluides Beschichtungsmaterial gewählt wird, welches das Material der Oberfläche der Unterlage (2) benetzt.

11. Verfahren nach Anspruch 9 oder 10, **dadurch gekennzeichnet, daß** das Verfestigen des Beschichtungsmaterials wenigstens einen der Schritte
- Vernetzen des Beschichtungsmaterials,
- Eintrocknen des Beschichtungsmaterials
umfaßt.

12. Verfahren nach einem der Ansprüche 9 bis 11, **dadurch gekennzeichnet, daß** das Auftragen eines fluiden Beschichtungsmaterials durch zumindest einen der Schritte
- Bedrucken mittels rechnergesteuertem Druckkopf, insbesondere mittels einem Inkjet- Druckkopf
- Bedrucken durch Siebdruck,
- Besprühen durch eine Maske
erfolgt.

13. Verfahren nach einem der Ansprüche 9 bis 13, **dadurch gekennzeichnet, daß** das Beschichtungsmaterial einen Licht-härtbaren Lack, insbesondere einen UV-härtbaren Lack umfaßt und das Verfestigen durch Belichten des Lacks erfolgt.

14. Verfahren nach einem der vorstehenden Ansprüche, **dadurch gekennzeichnet, daß** das Aufbringen einer Widerstandsschicht (7) mit zumindest einer Struktur (17) das Aufbringen einer Vorbeschichtung und das Verfestigen der Vorbeschichtung durch strukturierte Belichtung, insbesondere mittels eines gerasterten Strahls umfaßt.

15. Verfahren nach einem der vorstehenden Ansprüche, **dadurch gekennzeichnet, daß** auf der Widerstandsschicht (7) zumindest eine weitere Schicht, insbesondere mindestens eine Schicht (11) mit einem organischen, elektrolumineszenten Material durch Flüssigbeschichten aufgetragen wird.

16. Verfahren gemäß Anspruch 15, **dadurch gekennzeichnet, daß** das Flüssigbeschichten das Spin-Coaten oder das Tauchbeschichten umfaßt.

17. Verfahren gemäß einem der vorstehenden Ansprüche,
**dadurch gekennzeichnet, daß** das Aufbringen wenigstens einer Widerstandsschicht (7) mit zumindest einer Struktur (17) das Aufschmelzen von festem Beschichtungsmaterial umfaßt.

18. Verfahren nach einem der vorstehenden Ansprüche, **dadurch gekennzeichnet, daß** das Aufbringen der Widerstandsschicht (7) das Aufbringen einer Schicht durch Auftragen eines Pulvers, insbesondere eines pulverförmigen Polymers oder Lacks und Verfestigen des Beschichtungsmaterials durch Aufschmelzen umfaßt.

19. Verfahren nach Anspruch 18, **dadurch gekennzeichnet**, das zum Aufschmelzen des Pulvers Energie in einem Ofen, durch Bestrahlung mittels Licht, insbesondere durch Infrarot- oder Laserbelichtung, durch Mikrowellenstrahlung, Elektronen- oder Partikelstrahlung oder Induktion zugeführt wird.

20. Verfahren nach Anspruch 18 oder 19, **dadurch gekennzeichnet, dass** die Energie zum Aufschmelzen des Pulvers mit lokal variierender Intensität zugeführt wird.

21. Verfahren nach einem der vorstehenden Ansprüche, **dadurch gekennzeichnet, daß** die Widerstandsschicht (7) mit einer Schichtdicke in einem Bereich von 0,1 µm bis 100 µm, bevorzugt in einem Bereich von 0,1 µm bis 10 µm aufgebracht wird.

22. Verfahren nach einem der vorstehenden Ansprüche, **dadurch gekennzeichnet, daß** die Widerstandsschicht (7) durch Abziehen eines Abziehbildes aufgebracht wird.

23. Verfahren nach einem der vorstehenden Ansprüche, **dadurch gekennzeichnet, daß** das Aufbringen der Widerstandsschicht (7) das Abscheiden einer Widerstandsschicht durch Gasphasenbeschichtung, insbesondere durch Aufdampfen oder Sputtern, oder chemische Dampfphasenabscheidung umfaßt.

24. Verfahren nach einem der vorstehenden Ansprüche, **dadurch gekennzeichnet, daß** die Widerstandsschicht (7) so aufgebracht wird, daß die Struktur der Widerstandsschicht (7) Bereiche (31, 33, 35) mit stufenweise unterschiedlicher Schichtdicke aufweist.

25. Verfahren nach Anspruch 24, **dadurch gekennzeichnet, daß** die Bereiche (31, 33, 35) mit unterschiedlicher Schichtdicke durch mehrfaches Beschichten erzeugt werden.

26. Verfahren nach einem der vorstehenden Ansprüche, **dadurch gekennzeichnet, daß** die Widerstandsschicht (7) mehrere Schichten (71 - 74) mit unterschiedlichen Schichtmaterialien umfaßt, die nacheinander aufgebracht werden.

27. Verfahren nach einem der vorstehenden Ansprüche, **dadurch gekennzeichnet, daß** eine weitere Schicht (41) aufgebracht wird, welche Pigmente zur lokalen Variation der Helligkeit der Leuchtfläche aufweist.

28. Verfahren nach einem der vorstehenden Ansprüche, **dadurch gekennzeichnet, daß** das Aufbringen wenigstens einer Widerstandsschicht (7) mit zumindest einer Struktur (17), das Aufbringen einer Widerstandsschicht (7) mit mehreren Schichten (71 - 74) mit unterschiedlichen Farben oder Tönungen umfaßt, die nacheinander aufgebracht werden.

29. Verfahren nach einem der vorstehenden Ansprüche, **dadurch gekennzeichnet, dass** das Aufbringen wenigstens einer Widerstandsschicht (7) mit zumindest einer Struktur (17), das Aufbringen einer Widerstandschicht (7) umfaßt, welche ein ein- oder mehrfarbiges Muster oder Bild aufweist.

30. Verfahren gemäß einem der vorstehenden Ansprüche,
**dadurch gekennzeichnet, daß** das Aufbringen einer Widerstandsschicht (7) mit zumindest einer Struktur (17), den Schritt des Aufbringens einer Widerstandsschicht mit einer Rasterstruktur umfaßt.

31. Verfahren gemäß einem der vorstehenden Ansprüche, **dadurch gekennzeichnet, daß** entlang zumindest einem von der Widerstandsschicht (7) bedeckten Bereich (23) eine hoch leitfähige, insbesondere metallische Struktur (80) ausgebildet wird, welche in Kontakt mit einer der leitfähigen Schichten (5, 13), insbesondere mit einer transparenten leitfähigen Elektrodenschicht ist.

32. Verfahren gemäß Anspruch 31, **dadurch gekennzeichnet, daß** die leitfähige Struktur auf der zur Schicht mit dem organischen, elektrolumineszenten Material weisenden Seite der leitfähigen Elektrodenschicht (5, 13) angeordnet wird.

33. Verfahren gemäß Anspruch 31, **dadurch gekennzeichnet, daß** die hoch leitfähige Struktur auf der der Schicht (11) mit dem organischen, elektrolumineszenten Material abgewandten Seite der Elektrodenschicht (5, 13) angeordnet wird.

34. Organische lichtemittierende Diode (1), insbesondere herstellbar nach einem Verfahren gemäß einem der vorstehenden Ansprüche, welche
- eine Unterlage (2),
- eine auf der Unterlage (2) aufgebrachte erste leitfähige Elektrodenschicht (5),
- zumindest eine Schicht mit einem organischen, elektrolumineszenten Material (11), und
- eine zweite leitfähige Elektrodenschicht (13) umfaßt, **gekennzeichnet durch** eine Widerstandsschicht (7) mit zumindest einer Struktur (17), wobei die Oberfläche der Struktur (17) insbesondere in deren Randbereich (27) einen Winkel zur Oberfläche der Unterlage (2) einnimmt, der kleiner als 90° bleibt.

35. Diode nach Anspruch 34, **dadurch gekennzeichnet, daß** die Oberfläche der Struktur (17) insbesondere in deren Randbereich einen maximalen Winkel zur Oberfläche der Unterlage (2) einnimmt, der kleiner als 80°, vorzugsweise kleiner als 60°, besonders vorzugsweise kleiner als 45° bleibt.

36. Diode nach einem der Ansprüche 34 oder 35, **dadurch gekennzeichnet, daß** der Randwinkel der Struktur (17) zur Oberfläche der Unterlage kleiner als 80°, vorzugsweise kleiner als 60°, besonders vorzugsweise kleiner als 45° ist.

37. Diode nach einem der Ansprüche 34 bis 36, **dadurch gekennzeichnet, daß** das Aspektverhältnis des Randbereichs der Struktur (17) kleiner als 1, bevorzugt kleiner als 0,58 bleibt.

38. Diode nach einem der Ansprüche 34 bis 37, **dadurch gekennzeichnet, daß** die Oberfläche der Struktur (17) insbesondere in deren Randbereich einen Winkel zur Oberfläche der Unterlage einnimmt, der unterhalb von 10° bleibt, oder bei welcher der Randwinkel kleiner als 10° bleibt.

39. Diode nach einem der Ansprüche 34 bis 38, **dadurch gekennzeichnet, daß** zumindest eine auf der ersten leitfähigen Elektrodenschicht (5) aufgebrachte Schicht, insbesondere die Schicht mit einem organischen, elektrolumineszenten Material (11) durch Flüssigbeschichtung aufgebracht ist.

40. Diode nach einem der Ansprüche 34 bis 39, **dadurch gekennzeichnet, daß** die Oberfläche der Unterlage (2) in zumindest einen von der Widerstandsschicht (7) bedeckten (23) und zumindest einen nicht bedeckten Bereich (25) untergliedert ist.

41. Diode nach einem der Ansprüche 34 bis 40, **dadurch gekennzeichnet, daß** die Widerstandsschicht (7) auf der ersten leitfähigen Schicht (5) aufgebracht ist.

42. Diode nach einem der Ansprüche 34 bis 41, **dadurch gekennzeichnet, daß** zumindest eine der leitfähigen Elektrodenschichten (5, 13) transparent oder teilweise transparent für das von der Schicht (11) mit dem organischen, elektrolumineszenten Material erzeugte Licht ist.

43. Diode nach einem der Ansprüche 34 bis 42, **dadurch gekennzeichnet, daß** zumindest eine der leitfähigen Elektrodenschichten (5, 13) ein transparentes leitfähiges Oxid, bevorzugt Indium-Zinn-Oxid oder Zinnoxid umfaßt.

44. Diode nach einem der Ansprüche 34 bis 44, **dadurch gekennzeichnet, daß** die Widerstandsschicht (7) eine Schichtdicke in einem Bereich von 0,1 µm bis 100 µm, bevorzugt in einem Bereich von 1 µm bis 10 µm aufweist.

45. Diode nach einem der Ansprüche 34 bis 44, **dadurch gekennzeichnet, daß** die Struktur (17) der Widerstandsschicht (7) Bereiche (31, 33 ,35, 71 - 74) mit unterschiedlichem elektrischen Widerstand in Stromflußrichtung aufweist.

46. Diode nach einem der Ansprüche 34 bis 45, **dadurch gekennzeichnet, daß** die Struktur (17) der Widerstandsschicht (7) Bereiche (31, 33, 35) mit unterschiedlicher Schichtdicke aufweist.

47. Diode nach einem der Ansprüche 34 bis 46, **dadurch gekennzeichnet, daß** die Widerstandsschicht mehrere Schichten (71 - 74) mit unterschiedlichen Schichtmaterialien umfaßt.

48. Diode nach einen der Ansprüche 34 bis 47, **dadurch gekennzeichnet, daß** die Widerstandsschicht (7) farbig ist, insbesondere, daß die Widerstandsschicht (7) mehrere Schichten (71 - 74) mit unterschiedlichen Farben umfaßt.

49. Diode nach Anspruch 47 oder 48, **dadurch gekennzeichnet, dass** die Widerstandschicht (7) ein insbesondere von außen sichtbares ein- oder mehrfarbiges Muster oder Bild aufweist.

50. Diode nach einen der Ansprüche 34 bis 49, **dadurch gekennzeichnet, daß** die Widerstandsschicht (7) Gettersubstanzen aufweist.

51. Diode nach einen der Ansprüche 34 bis 50, **dadurch gekennzeichnet, daß** die Unterlage (2) transparent für das von der Schicht (11) mit dem elektrolumineszenten Material emittierte Licht ist.

52. Diode nach einen der Ansprüche 24 bis 38, **gekennzeichnet durch** eine weitere Schicht (41), welche eine laterale Variation der Lichtabsorption aufweist.

53. Diode gemäß einem der Ansprüche 34 bis 52, **dadurch gekennzeichnet, daß** die Struktur (17) der Widerstandsschicht (7) eine Rasterstruktur umfaßt.

54. Diode gemäß einem der Ansprüche 34 bis 53, **dadurch gekennzeichnet, daß** die Widerstandsschicht (7) eine Isolationsschicht umfaßt.

55. Diode gemäß einem der Ansprüche 34 bis 54, **gekennzeichnet durch** eine hoch leitfähige, insbesondere metallische Struktur (80), welche sich entlang zumindest einem von der Widerstandsschicht bedeckten Bereichs (23) erstreckt, wobei die hoch leitfähige Struktur (80) in Kontakt mit einer der leitfähigen Schichten (5, 13), insbesondere mit einer transparenten leitfähigen Elektrodenschicht ist.

56. Diode gemäß Anspruch 55, **dadurch gekennzeichnet, daß** die leitfähige Struktur (80) auf der zur Schicht (11) mit dem organischen, elektrolumineszenten Material weisenden Seite der leitfähigen Schicht (5, 13) angeordnet wird.

57. Diode gemäß Anspruch 55, **dadurch gekennzeichnet, daß** die hoch leitfähige Struktur (80) auf der der Schicht (11) mit dem organischen, elektrolumineszenten Material abgewandten Seite der Elektrodenschicht (5, 13) angeordnet wird.

58. Verwendung einer Diode gemäß einem der Ansprüche 34 bis 57
- als Leuchtmittel, oder
- als Beleuchtungmittel, oder
- als leuchtende Hinweis- oder Werbetafel, oder
- als variables Hinweisschild, oder
- zur Signalgebung oder Ambientebeleuchtung, insbesondere im Automobil-, Luftfahrt-, Schiffs- oder Küchenbereich, oder
- als hoch- oder niedrigauflösendes Display, oder
- als digitale Plakatwand oder Werbetafel.
